# EUROPEAN PATENT APPLICATION

(11) **EP 4 780 149 A1**
(43) Date of publication of application: **22.07.2026**
(21) Application number: 24865802.3
(22) Date of filing: 10.09.2024
(51) Int. Cl.: H05K 7/20

(54) **HEAT DISSIPATION DEVICE AND MANUFACTURING METHOD THEREFOR**

(30) Priority: 11.09.2023 KR 20230120506; 09.09.2024 KR 20240122392
(71) Applicant: KMW Inc., Hwaseong-si, Gyeonggi-do 18462 (KR)
(72) Inventor: JI, Kyo Sung, Hwaseong-si, Gyeonggi-do 18484 (KR); RYU, Chi Back, Hwaseong-si, Gyeonggi-do 18378 (KR); SEO, Jin Kook, Busan 46726 (KR); CHOI, Kyu Chul, Osan-si, Gyeonggi-do 18151 (KR); YANG, Won Seok, Hwaseong-si, Gyeonggi-do 18479 (KR); CHOI, In Hwa, Yongin-si, Gyeonggi-do 17148 (KR)
(74) Representative: impuls legal PartG mbB
(86) International application number: PCT/KR2024/013674
(87) International publication number: WO 2025/058363

(57) **Abstract**

The present invention relates to a heat dissipation device and a manufacturing method therefor. The heat dissipation device according to the present invention includes a heat-conduction panel body in which a refrigerant flow space having a predetermined thickness is formed to dissipate heat through a first surface and a second surface, wherein the heat-conduction panel body comprises a vacuumization portion installed on either the first surface or the second surface to communicate with the refrigerant flow space in a direction perpendicular thereto, the vacuumization portion being configured to vacuumize the refrigerant flow space before a refrigerant is filled into the refrigerant flow space or after the refrigerant is filled therein. Thus, there are the advantages of preventing a refrigerant leak in the heat dissipation device and improving heat dissipation performance.

## Description

### [Technical Field]

The present disclosure relates to a heat dissipation device and a manufacturing method thereof, and more particularly, to a heat dissipation device and a manufacturing method thereof, which can improve heat dissipation performance by actively transferring heat generated from a heat-generating device (e.g., an electronic device) through a phase change of a refrigerant that is more effective than thermal-conductive-material properties of the device itself.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, and displays. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

However, a conventional cooling system has limitations in dissipating a high level of heat generated by continuously developing and advanced technologies. Thus, there is a need in related industrial fields for innovative technologies capable of solving these problems, and as part of efforts to solve them, heat dissipation devices using phase change materials are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a substance is referred to as sensible heat, whereas the heat used during a phase change is referred to as latent heat.

However, the heat dissipation device has a problem in that pressure increases as temperature rises, because temperature and pressure are proportional to each other. When pressure increases due to high temperature conducted from a heating element within the sealed heat dissipation device, it may cause the heat dissipation device itself to rupture. To address this problem, it is necessary to prevent the pressure from increasing, and the heat dissipation device requires a sufficient internal volume to allow pressure equilibrium to be achieved during the phase-change circulation process of a substance.

As such, in order to dissipate heat using a phase-change material (refrigerant) provided inside the heat dissipation device, a vacuumization process for adjusting internal pressure is required before filling the refrigerant.

The vacuumization process is generally a process of creating a vacuum through internal pumping using a device operated by vacuum. The process is completed by forming an air vent hole portion to protrude further outward than an initial design value in order to form an air vent hole, performing the vacuumization process, and then performing a caulking finishing process so that the interior is sealed.

In this case, the caulking finishing process is a process completed by pressing an additionally protruding portion, formed to create the air vent hole, with a caulking tool so that inner circumferential surfaces defining the air vent hole come into contact with each other.

When the air vent hole initially has a perfectly circular cross-section, the shape is deformed by uniform pressure applied by the caulking tool, so that the inner circumferential surface of the air vent hole may be completely caulked without any leakage. However, when the air vent hole has a non-circular cross-section, including an elliptical shape, pressure transmitted by the caulking tool becomes non-uniform, resulting in unbalanced shape deformation, thereby creating a risk that leakage may occurs at certain portions.

Once leakage occurs in the heat dissipation device, the refrigerant may leak out, and in addition, a drop in internal pressure may make phase change of the refrigerant difficult, resulting in a rapid deterioration of heat dissipation performance.

### [Disclosure]

### [Technical Problem]

The present disclosure is proposed to resolve the aforementioned technical issues and is directed to providing a heat dissipation device and a manufacturing method thereof, which can improve heat dissipation performance of a heat-generating device (electronic device).

In addition, the present disclosure is also directed to providing a heat dissipation device and a manufacturing method thereof, including a vacuumization portion arranged to facilitate performance of a caulking finishing process for an air vent hole formed to have an elliptical or non-circular cross-section.

Technical issues of the present disclosure are not limited to the technical issues mentioned above, and other technical issues not mentioned above will be clearly understood by those skilled in the art from the following description.

### [Technical Solution]

A heat dissipation device according to an embodiment of the present disclosure includes a heat-conduction panel body in which a refrigerant flow space having a predetermined thickness is formed to dissipate heat through one surface and the other surface, and the heat-conduction panel body includes a vacuumization portion installed on either the one surface or the other surface to communicate with the refrigerant flow space in a direction perpendicular thereto, the vacuumization portion being configured to vacuumize the refrigerant flow space before a refrigerant is filled into the refrigerant flow space or after the refrigerant is filled therein.

The refrigerant flow space of the heat-conduction panel body may be a space between a first side heat-conduction panel forming the one surface and a second side heat-conduction panel forming the other surface, the refrigerant flow space being formed as a sealed empty space in which the refrigerant is filled and undergoes phase change to dissipate heat through vapor-liquid circulation, and the vacuumization portion may be provided in an air vent hole formed in either the first side heat-conduction panel or the second side heat-conduction panel.

The vacuumization portion may include an air vent tube caught from an inner side to an outer side of the air vent hole and protruding outward by a predetermined length, and a welding auxiliary ring mounted on an outer circumferential surface of the air vent tube to secure the air vent tube by welding.

The air vent tube may include a pipe-shaped tube body having a hollow portion, and a stepped locking portion of the tube body located in the refrigerant flow space and having an outer diameter greater than an outer circumference of the tube body.

The outer diameter of the stepped locking portion may be formed to have a size that is caught by an inner peripheral edge portion of the air vent hole.

The welding auxiliary ring may be fixed in close contact with an outer peripheral edge portion of either the first side heat-conduction panel or the second side heat-conduction panel in which the air vent hole is formed.

The vacuumization portion may further include a shielding solder portion configured to solder and fix the tube body to the air vent hole.

The shielding solder portion may be a filler material that is soldered to seal the hollow portion of the tube body after the tube body is cut so as to match an outer end of the welding auxiliary ring.

The shielding solder portion may be a filler material that is soldered to cover both the outer end of the welding auxiliary ring and the hollow portion of the tube body cut to match the outer end of the welding auxiliary ring.

The vacuumization portion may include an air vent tube caught from the outer side to the inner side of the air vent hole and protruding outward by a predetermined length, and the air vent tube may include a pipe-shaped tube body having a hollow portion, and a welding reinforcement portion integrally formed on the tube body and caught by an outer peripheral edge portion of the air vent hole.

A tapered portion may be formed at a portion of the welding reinforcement portion adjacent to the air vent hole, the tapered portion being inclined to define a space between the welding reinforcement portion and the outer peripheral edge portion of the air vent hole, into which a filler metal is applicable.

The welding reinforcement portion may have an outer diameter sized to be caught by the outer peripheral edge portion of the air vent hole when the tube body is inserted from the outer side to the inner side through the air vent hole.

The vacuumization portion may further include a shielding solder portion soldered by the filler material to seal the hollow portion of the tube body after the tube body is cut to match the outer end of the welding reinforcement portion, and a fixing solder portion soldered by a filler material to secure the welding reinforcement portion to the outer peripheral edge portion of the air vent hole.

The fixing solder portion may be formed by the filler material applied between the air vent hole and the tapered portion of the welding reinforcement portion.

A method of manufacturing a heat dissipation device according to an embodiment of the present disclosure includes a heat-conduction panel body sheet-metal forming process of machining a first side heat-conduction panel and a second side heat-conduction panel that define a refrigerant flow space therein, and integrally forming, in either the first side heat-conduction panel or the second side heat-conduction panel, an air vent hole for refrigerant filling or vacuumization, after the heat-conduction panel body sheet-metal forming process; a joining process of joining the first side heat-conduction panel and the second side heat-conduction panel to each other to form the refrigerant flow space, wherein the first and second side heat-conduction panels are formed of either a single metal panel member or two metal panel members; and after the joining process, a vacuumization process of vacuumizing the refrigerant flow space, and the vacuumization process includes a vacuumization-portion installation operation of installing a vacuumization portion in the air vent hole.

The method may further include, when the first side heat-conduction panel and the second side heat-conduction panel are formed of the single metal panel member, a bending process of bending the single metal panel member before the joining process such that the first side heat-conduction panel forms one side surface of the refrigerant flow space and the second side heat-conduction panel forms the other side surface of the refrigerant flow space.

The vacuumization-portion installation operation may include installing an air vent tube, prior to the joining process, such that the air vent tube is caught by an inner peripheral edge portion of the air vent hole and protrudes outward by a predetermined length, and mounting a welding auxiliary ring on an outer circumferential surface of the air vent tube protruding outward from the air vent hole.

The vacuumization process may further include an air vent operation of vacuumizing the refrigerant flow space using the air vent tube installed in the air vent hole, and a solder caulking operation of cutting a portion of the air vent tube after the air vent operation and then soldering a hollow portion of the air vent tube.

The vacuumization-portion installation operation may include, after the joining process, installing an air vent tube from an outer side toward an inner side so that the air vent tube is caught by an outer peripheral edge portion of the air vent hole, and mounting the air vent tube so as to be caught by the outer peripheral edge portion of the air vent hole.

The vacuumization process may further include an air vent operation of vacuumizing the refrigerant flow space using the air vent tube installed in the air vent hole, a solder fixing operation of soldering, by a filler metal, between a welding reinforcement portion integrally formed on the air vent tube and an outer circumferential surface of the air vent hole, after the air vent operation, and a solder caulking operation of cutting a portion of the air vent tube and then soldering a hollow portion of the air vent tube, after the air vent operation.

### [Advantageous Effects]

In a heat dissipation device and a manufacturing method thereof according to an embodiment of the present disclosure, leakage of a refrigerant from a completed heat dissipation device can be prevented, and a drop in internal pressure can also be avoided, thereby ensuring product quality.

Effects of the present disclosure are not limited to the effects mentioned above, and other effects not mentioned above will be clearly understood by those skilled in the art from the description of the claims.

### [Description of Drawings]

FIGS. 1A and 1B are perspective views illustrating two implementations of rear portions of antenna devices in which heat dissipation devices according to embodiments of the present disclosure are installed;
FIGS. 2A and 2B are exploded perspective views illustrating the rear portions of the antenna devices of FIGS. 1A and 1B, respectively;
FIG. 3 is a perspective view illustrating a finger guard assembly assembled to protect the heat dissipation device according to an embodiment of the present disclosure from the outside;
FIG. 4 is a perspective view illustrating a manufacturing process of the heat dissipation device according to an embodiment of the present disclosure referenced in FIGS. 1A and 2A;
FIG. 5 is a plan view illustrating a heat-conduction panel body among components of the heat dissipation device according to an embodiment of the present disclosure;
FIG. 6 is a perspective view and a partially enlarged plan view of the heat dissipation device according to an embodiment of the present disclosure referenced in FIGS. 1A and 2A;
FIG. 7 is a plan view of FIG. 6;
FIG. 8 is a cross-sectional view taken along line B-B of FIG. 7;
FIG. 9 is a perspective view illustrating a heat dissipation device according to another embodiment of the present disclosure;
FIG. 10 is an exploded perspective view of FIG. 9;
FIG. 11 includes a cutaway perspective view (a) of FIG. 9, a partially enlarged view (b) thereof, a cross-sectional view (c) of a corresponding portion, and a partially enlarged view (d) thereof;
FIG. 12 is a perspective view illustrating a vacuumization portion among components of a heat dissipation device according to embodiments of the present disclosure and a partially enlarged view thereof;
FIG. 13 is a cross-sectional view illustrating a vacuumization process using the vacuumization portion among components of the heat dissipation device according to embodiments of the present disclosure;
FIG. 14 is a partially cutaway perspective view of FIG. 13;
FIG. 15 is a perspective view illustrating another implementation of a vacuumization portion among the components of the heat dissipation device according to embodiments of the present disclosure and a partially enlarged cross-sectional view thereof;
FIG. 16 is a flowchart illustrating a manufacturing method of a heat dissipation device according to embodiments of the present disclosure;
FIG. 17 is a flowchart illustrating a detailed process of a vacuumization process SA of FIG. 16; and
FIG. 18 is a flowchart illustrating a detailed process of a remaining process SB of FIG. 16.

### <Description of reference numerals>

100: Antenna device 110: Heat-dissipation housing body
200: Heat dissipation device 1200: Heat dissipation device
200-1: First side heat-conduction panel 200-2: Second side heat-conduction panel
201: Press-fit end portion 203: Heat dissipation plate portion
210: First refrigerant flow path 215: Inclined guide
220: Second refrigerant flow path 230: Third refrigerant flow path
240: Multiple strength reinforcing portions 300: Absorber
301: Auxiliary absorber T: Arbitrary reference line
1200: Heat dissipation device 2000: Vacuumization portion
2100: Air vent tube 2100S: Hollow portion
2101: Tube body 2103: Stepped locking portion
2103': Weld reinforcement portion 2200: Weld auxiliary ring
2300: Solder portion

### [Mode for Invention]

Hereinafter, a heat dissipation device and a manufacturing method thereof according to an embodiment of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

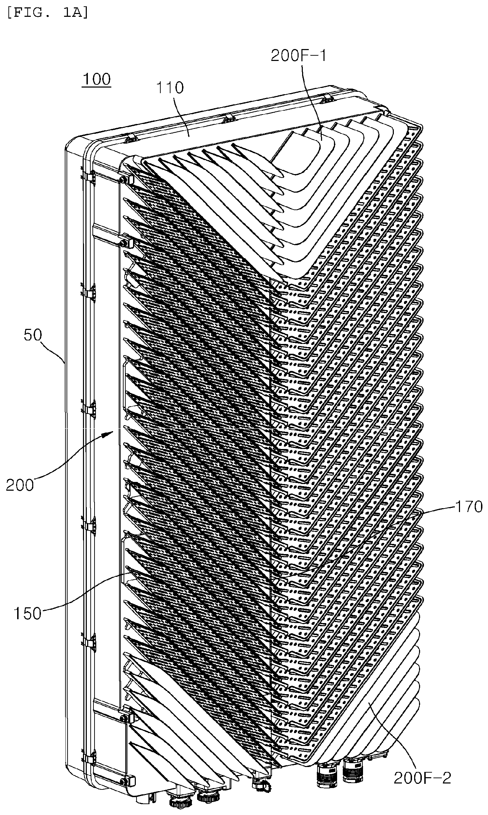

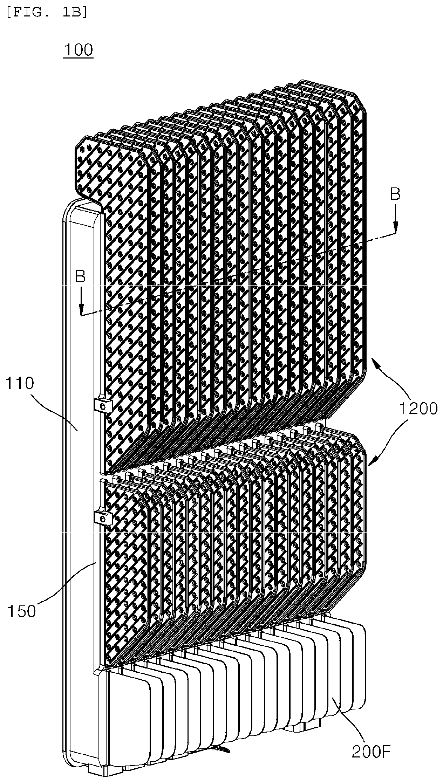

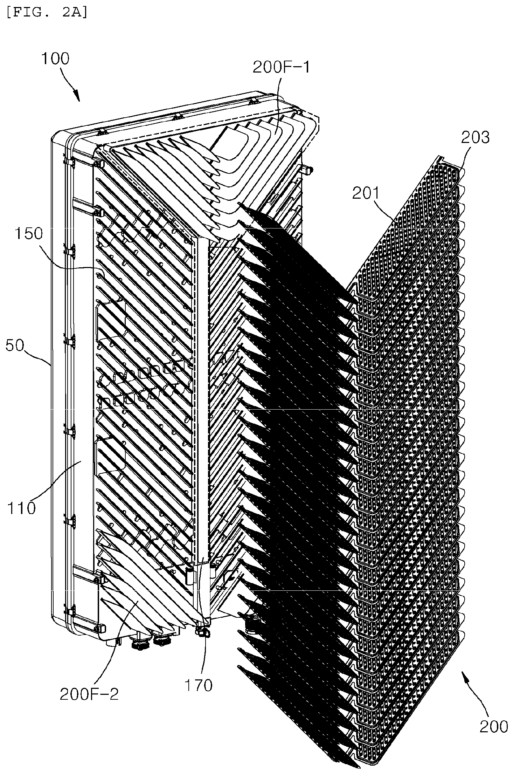

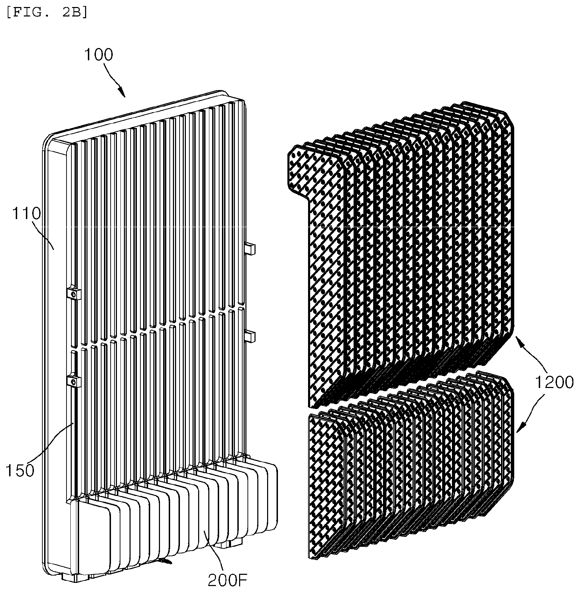

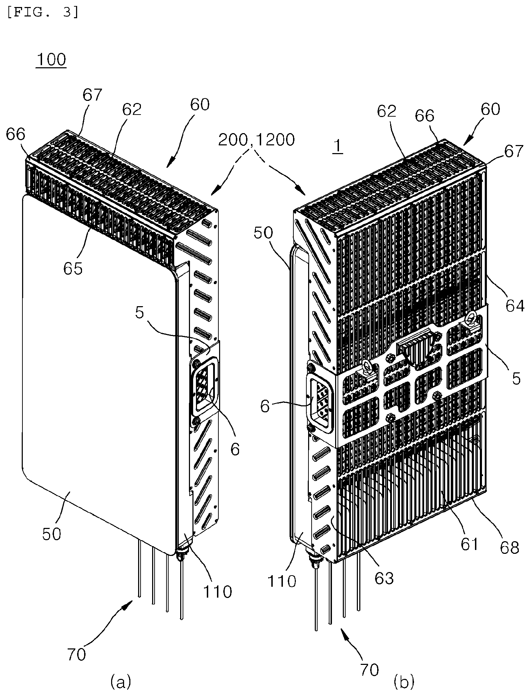

FIGS. 1A and 1B are perspective views illustrating two implementations of rear portions of antenna devices in which heat dissipation devices according to embodiments of the present disclosure are installed, FIGS. 2A and 2B are exploded perspective views illustrating the rear portions of the antenna devices of FIGS. 1A and 1B, respectively, and FIG. 3 is a perspective view illustrating a finger guard assembly assembled to protect the heat dissipation device according to an embodiment of the present disclosure from the outside.

In general, heat-generating devices (electronic devices) are manufactured in various forms across a wide range of industries. However, the applicant of the present disclosure is a company engaged in the manufacture of wireless communication equipment. Thus, in describing a heat dissipation device according to an embodiment of the present disclosure, an antenna device 100, which is very familiar to the applicant of the present disclosure, will be described as a specific example of a representative heat-generating device (electronic device) to be cooled.

However, the heat dissipation device according to embodiments of the present disclosure described below should not be construed as being limited only to the antenna device 100. It should be noted that the specific terms "antenna device 100" and "components related thereto" used below are to be interpreted as concepts encompassing all similar electronic devices and components thereof.

First, a description will be given of the antenna device 100 employed as a representative example of the electronic device.

As shown in FIGS. 1a and 1b, the antenna device 100 to which the heat dissipation device 200 according to embodiments of the present disclosure is applied includes a heat-dissipation housing body 110 formed in a rectangular parallelepiped shape that defines an accommodation space opened forward and has a long shape substantially in a vertical direction with a relatively narrow front-to-rear accommodation width.

Here, the heat-dissipation housing body 110 is provided in a robust material to provide an installation space (internal space) for various internal components to be described later and to protect the internal components from external impact. In particular, it is preferably formed of a metal material having excellent thermal conductivity so that heat generated during system operation by the internal components may be dissipated to the outside using thermal conductivity characteristics of the material itself.

Although not shown in the drawings, inside the accommodation space of the heat-dissipation housing body 110, a main board serving as a substrate for a PAU (Power Amplifier Unit) and a DTU (Digital Transceiving Unit) may be stacked and disposed, in which a plurality of MBF (Micro Bellows Filter) elements are mounted on a front surface thereof via a clamshell and a kind of heat-generating elements are mounted on a rear surface thereof.

Here, components defined as heat-generating elements (not shown), such as RFIC elements or PA elements that generate a large amount of heat during operation, may be mounted on the main board. However, in the embodiments of the present disclosure, the electronic device is merely described by adopting the antenna device 100 as an example, and it should be noted that the heat-generating elements are not limited to the above configuration. For example, the heat-generating elements may adopt semiconductors, which are representative heat-generating elements.

A radome panel 50 may be installed on the front of the accommodation space of the heat-dissipation housing body 110 to protect radiation elements implemented as antenna elements from the outside while allowing radiation from the radiation elements to be smoothly performed.

Here, since the radome panel 50 is formed of a nonconductive material through which radiation beams of the radiation elements may easily pass, it may be classified as a component that impedes dissipation of system operation heat generated in the accommodation space of the heat-dissipation housing body 110 toward a front side. Thus, in order to increase a heat dissipation surface area for concentrated heat dissipation toward a rear side of the heat-dissipation housing body 110, the heat-dissipation housing body 110 itself may be designed to extend longer in a vertical direction.

Meanwhile, heat dissipation devices 200 and 1200 according to embodiments of the present disclosure may be installed on the rear of the heat-dissipation housing body 110.

The heat dissipation devices 200 and 1200 according to embodiments of the present disclosure are provided in the form of heat dissipation fins and, more specifically, unlike fixed heat dissipation fins 200F, 200F-1, and 200F-2 shown in FIGS. 1A and 1B, may be characterized in that they are provided as thin vapor chamber types that essentially include an absorber 300 configured to absorb a liquid refrigerant therein.

In general, a well-known (already known) vapor chamber typically includes a wick member having a wick structure in which a plurality of pores are formed. Here, the wick member may be manufactured in a form in which metal powder is sintered to form a plurality of pores so that the liquid refrigerant filled inside a panel member made of a heat-conductive material is moved toward a side where the heat-generating element is provided by capillary force, while a vapor refrigerant may freely flow outward.

However, the wick member is not limited to the above-described sintered metal wick member. In particular, it may be defined as a concept encompassing any possible material, such as a fibrous material, regardless of its specific name including the absorber 300, as long as it may absorb and disperse the liquid refrigerant or promote vaporization thereof. This will be described in more detail later.

Meanwhile, the heat dissipation devices 200 and 1200 according to embodiments of the present disclosure may be manufactured by two different manufacturing methods.

That is, the heat dissipation devices 200 and 1200 according to embodiments of the present disclosure include heat-conduction panel bodies 200-1, 200-2, 1200-1, and 1200-2 having refrigerant flow spaces 205 and 1205 therein, in which a refrigerant is filled and flows while undergoing a phase change. In one embodiment, as shown in FIGS. 1A and 2A, a manufacturing method is employed in which the heat-conduction panel bodies 200-1 and 200-2, each provided as a single metal panel member, are bent through a bending process and then joined at remaining peripheral edge portions other than the bent portion. In another embodiment, as shown in FIGS. 1B and 2B, a manufacturing method is employed in which the heat-conduction panel bodies 1200-1 and 1200-2, each provided as two metal panel members, are directly joined without a bending process.

Meanwhile, the heat dissipation devices 200 and 1200 according to an embodiment of the present disclosure may further include a finger guard assembly 60 configured to surround a rear side and a portion of an upper side of the heat-dissipation housing body 110, as shown in FIGS. 3(a) and 3(b), so as to block access of an external object (or a person) to the heat dissipation devices 200 and 1200.

The finger guard assembly 60 may include a rear finger guard panel 61 provided vertically to cover an entire rear end of the heat dissipation device 200 or 1200, an upper top finger guard panel 62 having a rear end coupled to an upper end of the rear finger guard panel 61 and a front end extending horizontally forward, a right finger guard panel 63 having a front end coupled to a right rear end of the heat-dissipation housing body 110 and a rear end coupled to a right end of the rear finger guard panel 61, the right finger guard panel being disposed to cover a rear right portion of the heat-dissipation housing body 110, a left finger guard panel 64 having a front end coupled to a left rear end of the heat-dissipation housing body 110 and a rear end coupled to a left end of the rear finger guard panel 61, the left finger guard panel being disposed to cover a rear left portion of the heat-dissipation housing body 110, and an upper front finger guard panel 65 disposed to cover a space between a front end of the upper top finger guard panel 62 and a front upper end of the heat-dissipation housing body 110.

Here, the right finger guard panel 63 and the left finger guard panel 64 may include an upper side guard panel installed above a clamping bracket 5 to be described later and a lower side guard panel installed below the clamping bracket 5.

Meanwhile, the finger guard assembly 60 may further include guard mounting bars 66, 67, and 68 that provide predetermined screw fastening holes (reference numeral not shown) for screw coupling at respective edge portions and reinforce rigidity of the edge portions.

Here, the above-described rear to front finger guard panels 61 to 65 may be formed of a plastic material to reduce the overall weight of the antenna device 100, and the above-described guard mounting bars 66, 67, and 68 may be manufactured and provided in the form of aluminum extrusion bars to reinforce rigidity.

The guard mounting bars 66, 67, and 68 may further include a front guard mounting bar 66 disposed between the upper top finger guard panel 62 and the upper front finger guard panel 65 and providing a plurality of screw fastening holes, a rear guard mounting bar 67 disposed between the upper top finger guard panel 62 and the rear finger guard panel 61 and providing a plurality of screw fastening holes, and a lower guard mounting bar 68 disposed at a lower end of the rear finger guard panel 61 and having a plurality of screw fastening holes formed therein.

In addition, since the finger guard assembly 60 must allow air of an external space (outdoor air) to flow therein for heat exchange with the heat dissipation devices 200 and 1200 provided inside, a plurality of ventilation holes (not shown) in the form of a mesh (or grid) may be formed.

The finger guard assembly 60 having such a configuration may be arranged to surround all portions of the heat dissipation devices 200 and 1200 coupled to the rear portion of the heat-dissipation housing body 110 except for lower ends thereof, as shown in FIG. 3.

Meanwhile, the clamping brackets 5 for mediating mounting to a support pole (not shown) may be installed on left and right ends of the heat-dissipation housing body 110 so as to surround the outer surface of the rear finger guard panel 61 among the components of the above-described finger guard assembly 60.

The clamping brackets 5 not only mediate mounting to the support pole as described above, but may also function as handles allowing a worker in the field to hold and move the antenna device 100 by hand. For ease of gripping, handle holes 6 in the form of openings may be formed on left and right ends thereof.

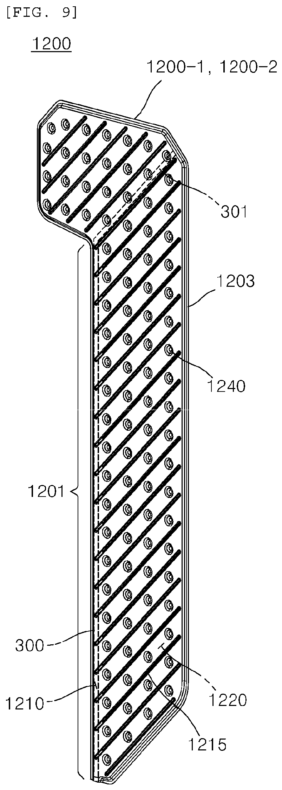

Hereinafter, the heat dissipation device 200 according to an embodiment of the present disclosure will be described in detail with reference to FIGS. 1A, 2A, and 4 to 8, and the heat dissipation device 1200 according to another embodiment of the present disclosure will be described in detail with reference to FIGS. 9 to 11.

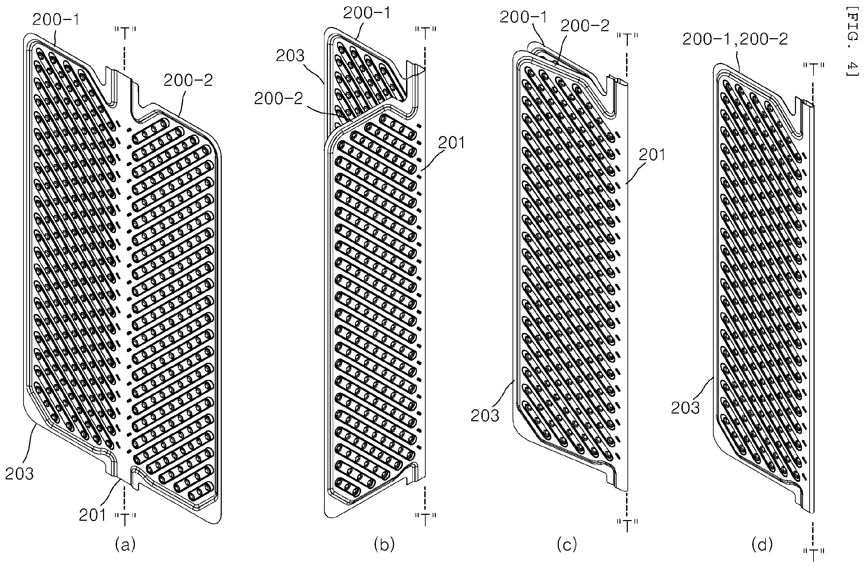

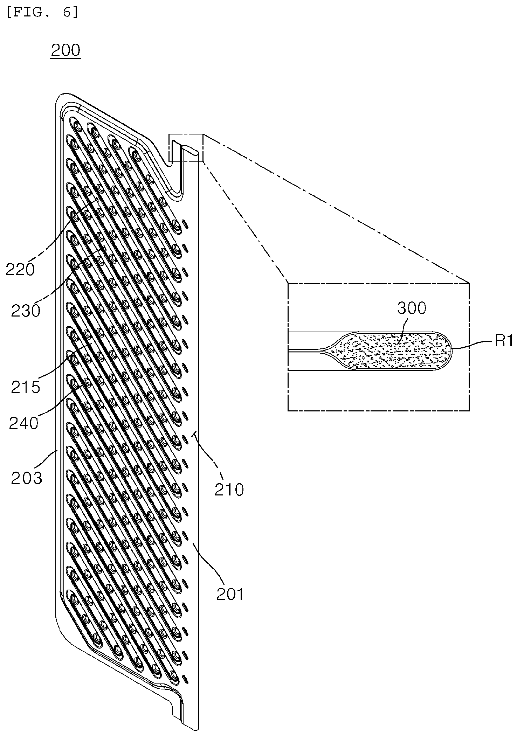

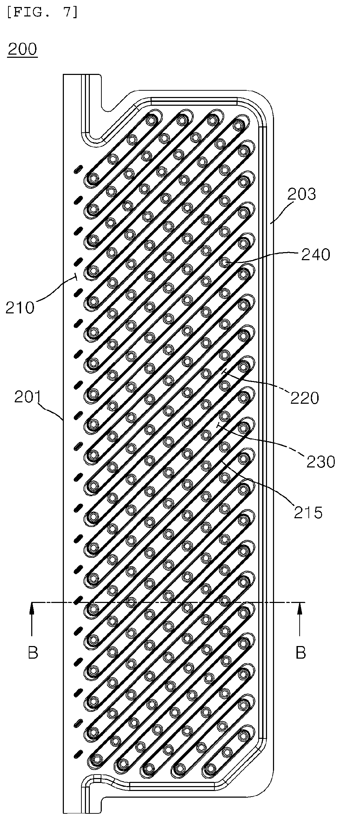

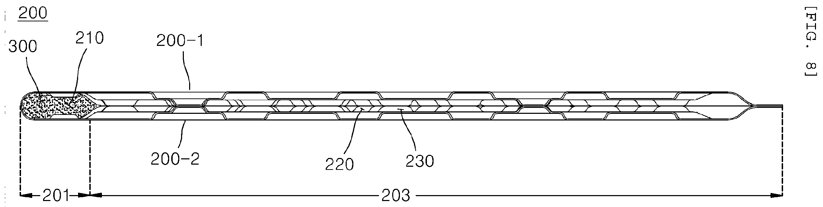

FIG. 4 is a perspective view illustrating a manufacturing process of the heat dissipation device according to an embodiment of the present disclosure referenced in FIGS. 1A and 2A,FIG. 5 is a plan view illustrating a heat-conduction panel body among components of the heat dissipation device according to an embodiment of the present disclosure, FIG. 6 is a perspective view and a partially enlarged plan view of the heat dissipation device according to an embodiment of the present disclosure referenced in FIGS. 1A and 2A, FIG. 7 is a plan view of FIG. 6, and FIG. 8 is a cross-sectional view taken along line B-B of FIG. 7.

First, the heat dissipation device 200 according to an embodiment of the present disclosure will be described in detail as follows.

As shown in FIGS. 1A and 2A, a plurality of heat dissipation devices 200 according to an embodiment of the present disclosure may be disposed on a rear surface of the heat-dissipation housing body 110 so as to be inclined upward toward respective left and right ends.

Meanwhile, the heat dissipation devices 200 according to embodiments of the present disclosure are provided in plurality and are all formed in an elongated rectangular shape having the same standard dimensions extending in the same longitudinal direction. Thus, the fixed heat dissipation fins 200F-1 and 200F-2 may be disposed on the rear portion of the heat-dissipation housing body 110 that is not occupied by the heat dissipation devices.

Here, as shown in FIGS. 1A and 2A, the fixed heat dissipation fins 200F-1 and 200F-2 may include an upper fixed heat dissipation fin 200F-1 disposed on an upper portion of the rear surface of the heat-dissipation housing body 110 not occupied by the heat dissipation device 200 according to embodiments of the present disclosure, and lower fixed heat dissipation fins 200F-2 disposed on left and right lower portions of the rear surface of the heat-dissipation housing body 110 not occupied by the heat dissipation device 200 according to embodiments of the present disclosure.

It should be noted in advance that, unlike the heat dissipation device 200 according to an embodiment of the present disclosure, the upper fixed heat dissipation fin 200F-1 and the lower fixed heat dissipation fins 200F-2 are not filled with a refrigerant therein and transfer heat according to thermal conductivity of the metal material itself.

However, the fixed heat dissipation fins 200F-1 and 200F-2 are not necessarily required to be separately provided on upper and lower portions as shown in FIGS. 1A and 2A. As in the heat dissipation device 1200 according to another embodiment of the present disclosure, it is also possible that a fixed heat dissipation fin 200F is provided only on a lower portion not occupied by the heat dissipation device 1200.

Meanwhile, as shown in FIGS. 1A and 2A, press-fit portions 150 may be formed on the rear surface of the heat-dissipation housing body 110 for press-fit installation of the plurality of heat dissipation devices 200 according to an embodiment of the present disclosure.

As described above, since the heat dissipation devices 200 according to an embodiment of the present disclosure are arranged to be inclined upward toward left and right ends with respect to the center (see reference numeral 170), the press-fit portions 150 may also be provided in plurality and may be arranged to form a "V" shape with respect to the center (see reference numeral 170).

That is, as shown in FIGS. 1A and 2A, the heat dissipation devices 200 according to an embodiment of the present disclosure may be press-fitted into the plurality of press-fit portions 150 formed on the rear surface of the heat-dissipation housing body 110 by a press-fit (interference-fit) method.

At this time, although not shown in the drawings, the press-fit portion 150 is preferably press-fitted after being treated with thermal epoxy in order to improve heat transfer efficiency.

Here, the press-fit portion 150 may be disposed to pass through at least one of heat-generating mating surfaces (not shown) formed to protrude rearward while being recessed so that heat-generating surfaces of the heat-generating elements 140 are accommodated on an inner surface corresponding to the rear side of the heat-dissipation housing body 110.

As shown in FIGS. 4 to 8, the heat dissipation device 200 according to an embodiment of the present disclosure includes heat-conduction panel bodies 200-1 and 200-2 having a refrigerant flow space 205 that provides a space in which a refrigerant is filled and circulates between vapor and liquid phases while undergoing phase change within a closed space to dissipate heat.

Here, the heat-conduction panel bodies 200-1 and 200-2 may be formed of a single metal panel member, which is shaped in a predetermined manner to form the refrigerant flow space 205.

In particular, the heat dissipation device 200 according to an embodiment of the present disclosure may directly form at least a first refrigerant flow path 210, to be described later, among the refrigerant flow spaces in which a refrigerant is filled and flows therein, through a bending process among predetermined methods.

That is, the first refrigerant flow path 210 is a portion of the single metal panel member that is shape-deformed through bending among the predetermined methods, and is formed such that a liquid refrigerant enters a space separated from the heat-generating element 140 or the press-fit portion 150 in which the heat-generating element 140 is provided, only by a separation distance corresponding to a material thickness of the metal panel member.

More specifically, the heat dissipation device 200 according to an embodiment of the present disclosure may be manufactured such that a sealed refrigerant flow space 205 is formed therein by bending the single heat-conduction panel body 200-1 and 200-2 with respect to a predetermined arbitrary reference line T to be described later (bending process S20) and then joining the same (joining process S40) .

However, the manufacturing method of the heat dissipation device according to the present disclosure is not necessarily limited to the above-described bending-type manufacturing method of the embodiment 200.

That is, as described above, it is also possible to use a manufacturing method of the heat dissipation device 1200 according to another embodiment of the present disclosure, in which two separate metal panel members are joined by a joining method (joining process S40) to form a sealed refrigerant flow space 1205 therein. This will be described in more detail later.

Here, the refrigerant flow space 205 may include the first refrigerant flow path 210 as described above, which is provided at a portion positioned relatively lower with respect to a direction of gravity.

The first refrigerant flow path 210 may be defined as a refrigerant filling and flow space in which a liquid refrigerant is contained, the space being formed as a portion shape-deformed through the bending (bending process S20) and spaced apart from the press-fit portion 150, in which the heat-generating elements are provided, by only a separation distance corresponding to a material thickness of the metal panel member.

Specifically, the separation distance refers to a distance by which the first refrigerant flow path 210 is spaced apart from the press-fit portion 150 in which the heat-generating elements are provided, and the separation distance may correspond to the material thickness of the metal panel member.

However, the definition of the first refrigerant flow path 210 in the heat dissipation device 200 according to an embodiment of the present disclosure is significant in that the first refrigerant flow path 210 includes a common technical configuration as an evaporation region located at one end in a width direction, where heat is supplied from the heat-generating element 140, which is a heat dissipation target, through the heat-conduction panel bodies 200-1 and 200-2.

Further, in the heat dissipation device 200 according to an embodiment of the present disclosure, the refrigerant flow space 205 may further include a plurality of second refrigerant flow paths 220 configured to guide a flow of the liquid refrigerant toward the first refrigerant flow path 210.

Here, when a portion in which the first refrigerant flow path 210 is provided, that is, a portion formed through the bending (bending process), is defined as the evaporation region in which the liquid refrigerant among the refrigerants evaporates, and the remaining portion other than the evaporation region is defined as a condensation region, the second refrigerant flow paths 220 may be provided in the condensation region.

In this case, a plurality of second refrigerant flow paths 220 may be formed in the condensation region excluding the first refrigerant flow path 210, and may serve as flow paths through which the liquid refrigerant, condensed from a vapor phase to a liquid phase at the other end of the heat-conduction panel bodies 200-1 and 200-2 in the width direction, flows toward the first refrigerant flow path 210 by surface tension or gravity.

More specifically, when the refrigerant in the vapor phase (vapor refrigerant) is condensed into a refrigerant in the liquid phase (liquid refrigerant) through a heat exchange process with outside air in the condensation region, the volume thereof gradually increases at the position within the refrigerant flow space 205 where condensation occurs, and, as it flows downward in a direction of gravity, a flow path is provided that enables a uniform amount of the liquid refrigerant to be supplied toward the first refrigerant flow path 210.

In particular, the second refrigerant flow paths 220 may be defined between a plurality of inclined guides 215, as will be described later. When the liquid refrigerant condensed in the condensation region flows downward toward the first refrigerant flow path 210, dispersive flow toward a second refrigerant flow path 220, which is adjacent to its own flow path, may be suppressed by surface tension. That is, since the plurality of inclined guides 215 define flow spaces narrower than the second refrigerant flow paths 220, surface tension acts therein, thereby restricting flow toward adjacent second refrigerant flow paths 220.

In addition, the plurality of second refrigerant flow paths 220 may be defined between the plurality of inclined guides 215 symmetrically protruding from opposing surfaces of the heat-conduction panel bodies 200-1 and 200-2 toward an interior of the refrigerant flow space.

More specifically, the plurality of second refrigerant flow paths 220 are defined as spaces between the plurality of inclined guides 215 formed on the same surface of each of the heat-conduction panel bodies 200-1 or 200-2. This is conceptually distinguished from a third refrigerant flow path 230, which is defined as a space between the plurality of inclined guides 215 protruding toward each other in a direction in which a thickness decreases toward the refrigerant flow space 205 of the heat-conduction panel bodies 200-1 and 200-2, as will be described later.

Referring to FIG. 4(a), the heat dissipation device 200 according to an embodiment of the present disclosure may simultaneously form the above-described first refrigerant flow path 210 and second refrigerant flow paths 220, and the plurality of inclined guides 215 to be described later for implementing the refrigerant flow paths, through a press process S10, which will be described later, applied to the heat-conduction panel bodies 200-1 and 200-2 made of a single member of a predetermined heat-conductive material.

At this time, when the heat-conduction panel bodies 200-1 and 200-2 are formed in a rectangular shape having a width in a left-right direction smaller than a length in an up-down direction as shown in FIG. 4, the arbitrary reference line T may be arranged to vertically cross a central portion between a left end and a right end, and may serve as a reference for a bending process (see FIGS. 4(b) and 4(c)) to be described later.

Referring to FIGS. 4(b) and 4(c), the first side heat-conduction panel 200-1 corresponding to the left side and the second side heat-conduction panel 200-2 corresponding to the right side may be bent through a bending jig (not shown) so as to contact each other with respect to the arbitrary reference line T.

At this time, not only the first refrigerant flow path 210 and the second refrigerant flow paths 220 but also, depending on the embodiment, the third refrigerant flow path 230 additionally formed may be provided. In addition, a plurality of strength reinforcing portions 240 required for a joining process S40 (see FIG. 3(d)) to be described later may be formed to face each other and come into surface contact.

Referring to FIG. 4(d), when the first side heat-conduction panel 2001-1 and the second side heat-conduction panel 2001-2 of the heat-conduction panel bodies 2001-1 and 2001-2 are brought into surface contact with each other, the peripheral edge portions thereof may be joined together using a predetermined joining method, and then the plurality of strength reinforcing portions 240 brought into surface contact may be joined together using a predetermined joining method.

At this time, one end and the other end of the first refrigerant flow path 210 formed through the bending process S20 may be formed such that the refrigerant flow space 205 communicates with the outside, while the remaining portion (heat dissipation plate portion 203) may be hermetically coupled so that the refrigerant flow space is completely sealed from the outside.

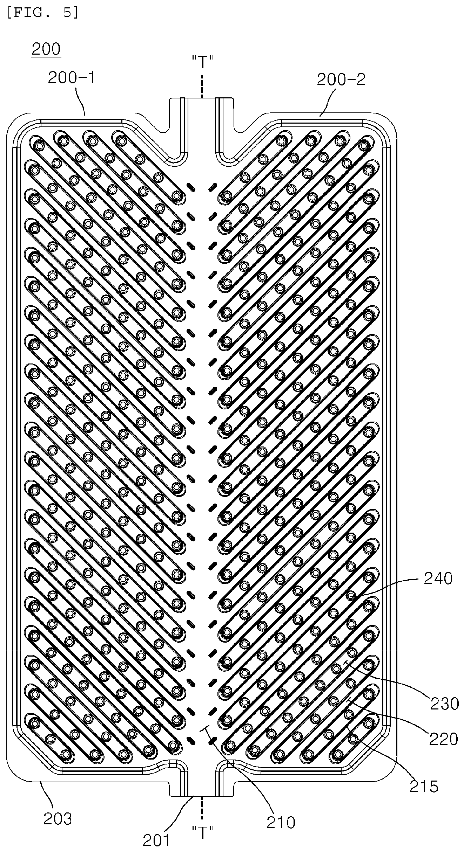

More specifically, as shown in FIG. 5, the heat dissipation device 200 according to an embodiment of the present disclosure includes, with respect to the arbitrary reference line T defined as the straight line in the up-down direction, the first side heat-conduction panel 200-1 forming a left end before the bending process S20 and the second side heat-conduction panel 200-2 forming a right end before the bending process S20. Here, the first side heat-conduction panel 200-1 and the second side heat-conduction panel 200-2 may be understood as defining the heat-conduction panel bodies 200-1 and 200-2 before the bending process S20.

However, the heat-conduction panel bodies 200-1 and 200-2 may be redefined as configurations after the bending process S20 to be described later.

For example, the heat-conduction panel bodies 200-1 and 200-2 may be defined as portions formed by the bending process S20 and the joining process S40 to be described later, and may include press-fit end portions 201 press-fitted and coupled to the press-fit portions 150 formed to be inclined upward to the left and right, respectively, with respect to a center (see reference numeral 170 of FIG. 2A) of the rear surface of the heat-dissipation housing body 110 to be cooled, and heat dissipation plate portions 203 corresponding to peripheral edge portions of the heat-conduction panel bodies 200-1 and 200-2 excluding the press-fit end portion 201, each heat dissipation plate portion 203 performing heat dissipation according to phase change of the refrigerant.

However, the heat dissipation plate portion 203 is preferably defined as all regions, excluding the above-described press-fit end portion 201, that perform heat dissipation after heat exchange with the refrigerant filled therein.

Here, in the heat dissipation plate portion 203, the plurality of strength reinforcing portions 240 may be formed to protrude into the refrigerant flow space from inner surfaces of the first side heat-conduction panel 200-1 and the second side heat-conduction panel 200-2, which are spaced apart from each other in the thickness direction.

In addition, as will be described later, the plurality of strength reinforcing portions 240 are simultaneously formed together with the second refrigerant flow paths 220, the third refrigerant flow paths 230, and the plurality of inclined guides 215 through a press process. Thus, when observed from the outside after the bending process S20 and the joining process S40, the strength reinforcing portions 240 may be understood as being formed to be recessed inward from an exterior of the heat dissipation plate portion 203.

The first refrigerant flow path 210 may be defined as a flow path that is positioned at a lower side with respect to the direction of gravity, and that collects the liquid refrigerant and uniformly moves and distributes the liquid refrigerant over the entire evaporation region where the refrigerant is changed into a vapor phase by heat transmitted from the heat-generating elements 140 of the heat-dissipation housing body 110, when the refrigerant that has undergone phase change mainly into the liquid refrigerant within the refrigerant flow space flows downward along the direction of gravity.

In this regard, the function of uniformly moving and distributing the liquid refrigerant in the first refrigerant flow path 210 may conceptually mean transporting the liquid refrigerant in a direction different from the direction of gravity by means of the absorber 300 to be described later. This will be described in more detail in the section relating to the absorber 300.

The absorber 300 to be described later may be inserted and installed inside the first refrigerant flow path 210, thereby promoting collection and distribution of the above-described liquid refrigerant and transport thereof in a direction different from the direction of gravity.

Here, after the above-described bending process S40, the first refrigerant flow path 210 may be formed symmetrically with respect to the arbitrary reference line T in a thickness direction of the refrigerant flow space.

As such, as shown in FIGS. 5 and 6, the heat-conduction panel bodies 200-1 and 200-2 may be bent with respect to the arbitrary reference line T such that the first side heat-conduction panel 200-1 and the second side heat-conduction panel 200-2 form the first refrigerant flow path 210 therein and, on an outer side, form the press-fit end portion 201 coupled to the press-fit portion 150 formed on the rear surface of the heat-dissipation housing body 110 to be cooled.

In addition, as defined above, the heat-conduction panel bodies 200-1 and 200-2 may further include the heat dissipation plate portion 203 defined as a remaining portion excluding the press-fit end portion 201.

In the heat dissipation plate portion 203, after the bending process S20, respective peripheral edge portions of the first side heat-conduction panel 200-1 and the second side heat-conduction panel 200-2 may be joined to each other by the predetermined joining method to seal the refrigerant flow space 205.

The predetermined joining method may be either a welding method or a bonding method. Preferably, a laser welding method may be adopted. However, it is not necessarily required to adopt the laser welding method, and any joining method may be employed as long as it provides a sealing force sufficient to prevent leakage of the refrigerant filled therein.

Meanwhile, as shown in FIG. 6, an end of the press-fit end portion 201 inserted into the press-fit portion 150 may be formed to have a semicircular rounded cross-section with a radius of R1.

An outer surface of the press-fit end portion 201 having such a shape may be installed by the press-fit method after thermal epoxy treatment is applied to the press-fit portion 150.

In addition, when the press-fit end portion 201 is inserted into the press-fit portion 150, at least a portion of the first refrigerant flow path 210 may introduced into an inner side of a distal end of the press-fit portion 150.

Meanwhile, the second refrigerant flow paths 220 may serve to guide refrigerant that has undergone phase change into the vapor phase (vapor refrigerant), flowed toward the heat dissipation plate portion 203, and exchanged heat with outside air, and then condensed back into the liquid phase (liquid refrigerant), so that the condensed refrigerant naturally flows down toward the first refrigerant flow path 210.

More specifically, as shown in FIGS. 4 to 8, the second refrigerant flow paths 220 may be provided in the condensation region formed in portions other than the first refrigerant flow path 210 and may be defined between the plurality of inclined guides 215 that guide the flow of liquid refrigerant, which has undergone phase change from the vapor phase to the liquid phase, toward the evaporation region.

Here, as shown in FIG. 5, the plurality of inclined guides 215 defining the second refrigerant flow paths 220 may be provided in a form protruding toward the refrigerant flow space 205 from respective inner surfaces of the first side heat-conduction panel 200-1 and the second side heat-conduction panel 200-2 after the bending process S20 to be described later.

The plurality of inclined guides 215 may be provided in a straight-line form inclined downward in the direction of gravity toward the first refrigerant flow path 210. Thus, the liquid refrigerant condensed on the heat dissipation plate portion 203 may naturally aggregate and then flow down toward the first refrigerant flow path 210 along spaces between the plurality of inclined guides 215 inclined downward, and may serve to enhance a phase change rate by minimizing an interval of a vapor-liquid circulation cycle corresponding to phase change between the liquid refrigerant and the vapor refrigerant.

Here, the plurality of second refrigerant flow paths 220 or the plurality of inclined guides 215 may be arranged such that adjacent second refrigerant flow paths 220 or inclined guides 215 are parallel to each other. Thus, liquid refrigerant condensed in a wide condensation region having a larger area than the evaporation region limited to the first refrigerant flow path 210 may be dispersed through the second refrigerant flow paths 220 or the inclined guides 215 that are densely and uniformly arranged in parallel, thereby providing an advantage in that heat is dissipated over the entire condensation region (e.g., the heat dissipation plate portion 203) with uniform heat dissipation performance.

In addition, the plurality of inclined guides 215 may be formed on each of the first side heat-conduction panel 200-1 and the second side heat-conduction panel 200-2, and may be configured such that respective distal ends protruding toward the refrigerant flow space 205 are not joined to each other within the refrigerant flow space 205 but are spaced apart from each other.

As such, since the second refrigerant flow paths 220 function to guide the flow of the liquid refrigerant in the direction of gravity, it is preferable that they have a thickness-direction dimension that allows the flow to be naturally formed in the direction of gravity without being stopped by surface tension, which is an inherent characteristic of liquid. Further, the second refrigerant flow paths 220 may be formed such that, after the liquid refrigerant is aggregated to at least a predetermined size, dispersive flow toward adjacent second refrigerant flow paths 220 due to surface tension or gravity is suppressed.

In addition, at least one of one end and the other end of the plurality of second refrigerant flow paths 220 or the plurality of inclined guides 215 may be connected to the first refrigerant flow path 210, and the end connected to the first refrigerant flow path 210 may be positioned relatively lower in the direction of gravity.

Furthermore, at least one of one end and the other end of the plurality of second refrigerant flow paths 220 or the plurality of inclined guides 215 may be connected to the first refrigerant flow path 210, and the one end and the other end may be formed to be connected in a straight line.

As such, not only is a distance between the first refrigerant flow path 210 (i.e., one end), which is positioned closest to the heat-generating elements and receives heat therefrom, and outer ends (i.e., the other ends) of the plurality of second refrigerant flow paths 220, in which condensation is actively performed through heat exchange with outside air, very short, but also the linear configuration of the second refrigerant flow paths 220 themselves enables miniaturization of the overlapping length (flow resistance length) between the flow path of the liquid refrigerant and the flow path of the vapor refrigerant, thereby forming an optimal shape.

Meanwhile, as described above, the plurality of inclined guides 215 may define the second refrigerant flow paths 220, which are spaces between respective inclined guides 215, as flow paths guiding the flow of the liquid refrigerant in the direction of gravity.

Here, the second refrigerant flow paths 220 defined as spaces between adjacent inclined guides 215 may be refrigerant flow paths extending upwardly inclined from the first refrigerant flow path 210 corresponding to the reference line T toward width-direction ends of the heat-conduction panel bodies 200-1 and 200-2. This is to allow the liquid refrigerant liquefied at the heat dissipation plate portion 203 side to be easily moved by its own weight toward the first refrigerant flow path 210 in which the absorber 300 is provided.

Meanwhile, as shown in FIGS. 5 to 8, the heat dissipation device 200 according to an embodiment of the present disclosure may further include a third refrigerant flow path 230.

Here, when the bending process and the joining process are completed, the heat-conduction panel bodies 200-1 and 200-2 may form the refrigerant flow space 205 as a portion of one surface of the first side heat-conduction panel 200-1 and a portion of one surface of the second side heat-conduction panel 200-2 are joined to each other with respect to the arbitrary reference line T. Simultaneously with the joining process S40, the refrigerant flow space 205 may define the first refrigerant flow path 210, the second refrigerant flow paths 220, and, depending on the embodiment, the third refrigerant flow path 230 added thereto.

The second refrigerant flow paths 220 are formed on each of the first side heat-conduction panel 200-1 and the second side heat-conduction panel 200-2 and are defined as spaces between adjacent inclined guides 215, whereas the third refrigerant flow path 230 may be defined as a space between the inclined guide 215 formed on the first side heat-conduction panel 200-1 and the inclined guide 215 formed on the second side heat-conduction panel 200-2.

The third refrigerant flow path 230 may serve to provide a gas flow path so that refrigerant filled in the refrigerant flow space 205, after undergoing phase change into vapor refrigerant in the first refrigerant flow path 210 serving as the evaporation region, may easily diffuse and flow throughout the heat dissipation plate portion 203. The vapor refrigerant evaporated in the first refrigerant flow path 210, which is the evaporation region, may move toward the heat dissipation plate portion 203 and be smoothly and evenly dispersed through the third refrigerant flow path 230, thereby performing heat dissipation and condensation.

For example, when the liquid refrigerant naturally flows down through spaces between the inclined guides 215 adjacent to the second refrigerant flow paths 220, the vapor refrigerant may actively flow through the third refrigerant flow path 230, which is a space not occupied by the liquid refrigerant.

However, this does not mean that the liquid refrigerant is completely separated from the vapor refrigerant and does not occupy the third refrigerant flow path 230. Rather, it is preferable to understand that the vapor refrigerant flows more actively through the third refrigerant flow path 230.

That is, since the phase change of the refrigerant does not occur with the liquid refrigerant and the vapor refrigerant being completely separated, it is difficult to define this precisely. However, in general, the second refrigerant flow paths 220, each having a relatively larger dimension in the thickness direction, may serve as paths through which the liquid refrigerant mainly flows, whereas the third refrigerant flow path 230 may serve as a path through which the vapor refrigerant mainly flows.

Meanwhile, as shown in FIGS. 4 to 8, the heat dissipation device 200 according to an embodiment of the present disclosure may further include a plurality of strength reinforcing portions 240 formed on at least one of the first side heat-conduction panel 200-1 and the second side heat-conduction panel 200-2, protruding by a predetermined length from inner surfaces of the first side heat-conduction panel 200-1 and the second side heat-conduction panel 200-2 toward the refrigerant flow space 205, and formed to face each other.

The plurality of strength reinforcing portions 240 may generally be formed on at least one of the first side heat-conduction panel 200-1 and the second side heat-conduction panel 200-2, each of which has a planar shape, and may serve to reinforce strength so as to prevent sagging or deformation due to external pressure.

Here, the plurality of strength reinforcing portions 240 may be formed such that end surfaces thereof protrude toward the refrigerant flow space 205 by at least a greater amount than ends of the plurality of inclined guides 215 after bending according to the bending process S20. At this time, it is preferable that an amount by which the end surfaces of the plurality of strength reinforcing portions 240 protrude toward the refrigerant flow space 205 be such that, during the joining process S40 after the bending process S20 to be described later, opposing portions of the first side heat-conduction panel 200-1 and the second side heat-conduction panel 200-2 may come into surface contact so as to be joined by a predetermined joining method. However, the plurality of strength reinforcing portions 240 do not necessarily need to be in surface contact with each other after bending, and may be spaced apart from each other within the refrigerant flow space, like the inclined guides 215 described above.

Meanwhile, as shown in FIGS. 4 and 8, the heat dissipation device 200 according to an embodiment of the present disclosure may further include an absorber 300 configured to absorb liquid refrigerant among the refrigerant phases guided through the second refrigerant flow paths 220 and to uniformly distribute the absorbed liquid refrigerant to the first refrigerant flow path 210.

Here, the absorber 300 is a concept that includes a wick member having a wick structure provided inside a general vapor chamber; however, it is not limited thereto. Rather, the absorber may encompass any material or configuration capable of collecting and transporting liquid refrigerant over the entire upper and lower regions of the first refrigerant flow path 210, which is inclined with respect to the direction of gravity, thereby overcoming material limitations in thermal conductivity of conventional heat dissipation fins formed in a typical heat sink fin type and maximizing heat dissipation performance.

Meanwhile, the absorber 300 is preferably installed as close as possible to the press-fit end portion 201, since, the closer it is to the press-fit end portion 201, the more readily the liquid refrigerant may undergo phase change into the vapor refrigerant due to heat transferred from the heat-generating elements 140.

However, the absorber 300 is not necessarily required to be installed only near the press-fit end portion 201, and it may also be installed so as to be evenly distributed over the entire evaporation region in which the refrigerant may evaporate.

However, in the case of the heat dissipation device 200 according to an embodiment of the present disclosure, since the heat-conduction panel bodies 200-1 and 200-2 provided as a single member are bent and then portions corresponding to peripheral edge portions of the heat dissipation plate portion 203 are joined to each other, and the absorber 300 is installed through open portions at both ends of the first refrigerant flow path 210, the evaporation region of the refrigerant may be limited to the first refrigerant flow path 210 for reasons related to the manufacturing method.

Here, the absorber 300 may include either a nonwoven fabric forming a plurality of pores (a kind of wick structure) or a nonwoven fabric coupled to a braided body made of copper wire.

That is, the absorber 300 may be adopted as a nonwoven fabric itself made of a fibrous material. In this case, since the nonwoven fabric material itself is highly flexible and may have difficulty maintaining its shape in a vertical direction due to the weight of the absorbed liquid refrigerant when the liquid refrigerant is absorbed, the braided body made of copper wire may be included in the nonwoven fabric to maintain its shape. Thus, the nonwoven fabric serving as the absorber 300 may be stably fixed on the first refrigerant flow path 210 so as not to be moved.

In addition, as shown in FIG. 5, the heat dissipation device 200 according to an embodiment of the present disclosure may further include a plurality of absorber fixing guides 250 that are simultaneously formed during the press process S10 together with the above-described first to third refrigerant flow paths 210 to 230, the plurality of inclined guides 215, and/or the plurality of strength reinforcing portions 240.

The plurality of absorber fixing guides 250 may be formed to protrude toward the refrigerant flow space 205 so as to prevent the absorber 300, adopted as a nonwoven fabric, from sagging in the direction of gravity when it absorbs the liquid refrigerant. When the first side heat-conduction panel 200-1 and the second side heat-conduction panel 200-2 are bent by the bending process S20, the absorber fixing guides may press the absorber 300 to stably secure it in place.

In addition, the plurality of absorber fixing guides 250 may also press the outer surface of the absorber 300 made of the nonwoven fabric, thereby securing a space through which refrigerant in a vapor phase (vapor refrigerant) evaporated within the first refrigerant flow path 210 may flow.

As such, since the absorber 300 is installed in the first refrigerant flow path 210, the liquid refrigerant liquefied from the heat dissipation plate portion 203 may move toward a portion close to the heat-generating elements 140 by an absorption force (or capillary force) of the absorber 300, and then the vapor refrigerant that has undergone phase change due to heat transmitted from the heat-generating elements 140 may move again toward the heat dissipation plate portion 203.

The vapor refrigerant moved to the heat dissipation plate portion 203 may be smoothly and evenly distributed throughout the entire heat dissipation plate portion 203 through the third refrigerant flow path 230 to be condensed while performing heat dissipation, and the condensed liquid refrigerant may be easily moved again toward the first refrigerant flow path 210 in the direction of gravity along the second refrigerant flow paths 220, which have a relatively larger thickness-direction dimension.

Heat generated from the heat-generating elements 140 may be primarily transferred to the first refrigerant flow path 210 in which the absorber 300 is installed. The refrigerant stored in the first refrigerant flow path 210 provided with the absorber 300 may mostly remain in the liquid phase and then undergo phase change into the vapor phase due to the heat transferred from the heat-generating elements 140. Thereafter, the vapor refrigerant may preferably flow through the third refrigerant flow path 230 to the entire heat dissipation plate portion 203 of the heat-conduction panel bodies 200-1 and 200-2, thereby performing heat dissipation.

Meanwhile, recent antenna devices to which Massive MIMO technology is applied are generally manufactured to be longer in a vertical length direction rather than in a width direction. In order to cover heat generated by the plurality of heat-generating elements 140 spaced apart in the vertical direction using a minimum number of heat dissipation devices 200, the heat dissipation devices need to be manufactured to be as long as possible in the longitudinal direction.

However, when the heat-conduction panel bodies 200-1 and 200-2 are formed to be long in one direction (e.g., the direction of gravity), the length of the first refrigerant flow path 210 in the direction of gravity inevitably becomes longer. In such a case, it is very difficult to sufficiently draw up and distribute the liquid refrigerant from a lower end to an upper end in the direction of gravity solely by the absorption force of the absorber 300 itself, and due to differences in absorption rate of the liquid refrigerant along the direction of gravity, heat dissipation performance may also become non-uniform depending on position.

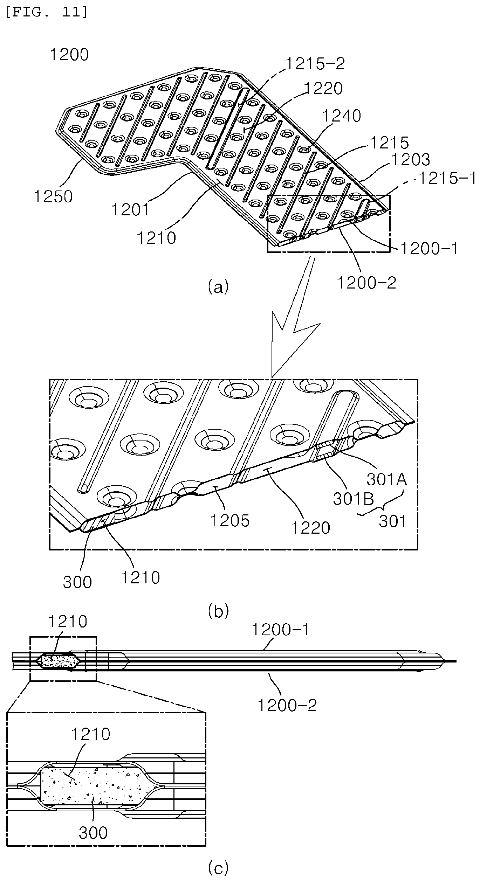

In order to resolve such non-uniform heat dissipation performance, the heat dissipation device 200 according to an embodiment of the present disclosure may further include an auxiliary absorber 301 disposed in some of the plurality of inclined guides 215 forming the second refrigerant flow paths 220, as shown in FIG. 11 to be described later.

The auxiliary absorber 301 may serve to induce collection of the liquid refrigerant at an upper end of the absorber 300, positioned relatively higher in the direction of gravity, in the absorber 300 disposed long in the longitudinal direction.

That is, as shown in FIG. 11, the liquid refrigerant condensed and falling from a portion of the heat dissipation plate portion 203 positioned relatively higher in the direction of gravity may be collected and supplied to the upper end of the absorber 300. Thus, the auxiliary absorber may disperse and draw the liquid refrigerant further upward in the direction of gravity from a position at which the liquid refrigerant is supplied, thereby compensating for heat dissipation performance in portions of the existing absorber 300 where the absorption rate is low.

In addition, since high-temperature vapor refrigerant evaporated at a lower side in the direction of gravity generally moves upward and concentrates in an upper region of the refrigerant flow space, it may be difficult to sufficiently dissipate heat at an upper end of the refrigerant flow space due to a lack of sufficient condensation space (condensation region). The auxiliary absorber 301 may continuously supply a portion of the liquid refrigerant flowing downward from the upper side of the refrigerant flow space to the first refrigerant flow path 210 corresponding to the upper end of the absorber 300, thereby enabling overall uniform heat dissipation.

However, although only a single auxiliary absorber 301 is illustrated in FIG. 11 for convenience of understanding, it should be understood that a plurality of auxiliary absorbers 301 may be installed at predetermined intervals in the vertical direction of the gravitational direction, considering the longitudinal length of the heat dissipation device 200 according to an embodiment of the present disclosure.

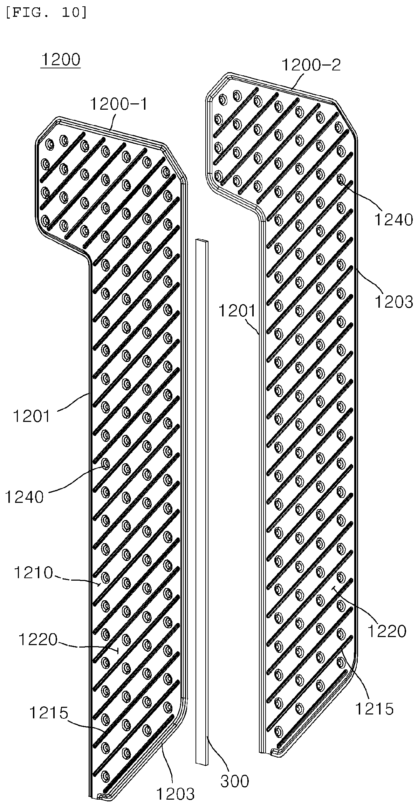

FIG. 9 is a perspective view illustrating a heat dissipation device according to another embodiment of the present disclosure, FIG. 10 is an exploded perspective view of FIG. 9, FIG. 11 includes a cutaway perspective view (a) of FIG. 9, a partially enlarged view (b) thereof, a cross-sectional view (c) of a corresponding portion, and a partially enlarged view (d) thereof.

Up to this point, as shown in FIGS. 1A and 2A and FIGS. 4 to 8, the heat dissipation device 200 according to an embodiment of the present disclosure has been described in detail, focusing on an embodiment manufactured by a manufacturing method in which the refrigerant flow space 205 is formed through the joining process S40 after the bending process S20 of the single metal panel member.

However, the manufacturing method of the heat dissipation device according to the present disclosure is not necessarily limited to the above-described bending process S20. Hereinafter, as shown in FIGS. 1B and 2B and FIGS. 9 to 11, a heat dissipation device 1200 according to another embodiment will be proposed, in which a refrigerant flow space 1205 including a first refrigerant flow path 1210 and a second refrigerant flow path 1220 is formed by joining two separate metal panel members through a joining method.

In the heat dissipation device 1200 according to another embodiment of the present disclosure, as shown in FIGS. 9 to 11, heat-conduction panel bodies 1200-1 and 1200-2 may form the refrigerant flow space 1205 by joining two separate metal panel members through the joining method. The heat-conduction panel bodies may include a first side heat-conduction panel 1200-1 forming one surface in a thickness direction of the refrigerant flow space 1205 after joining, and a second side heat-conduction panel 1200-2 forming the other surface in the thickness direction of the refrigerant flow space 1205 after joining.

Here, the first refrigerant flow path 1210 and the second refrigerant flow path 1220 may be formed symmetrically with respect to a joining surface between the first side heat-conduction panel 1200-1 and the second side heat-conduction panel 1200-2.

The joining surface of the first side heat-conduction panel 1200-1 and the second side heat-conduction panel 1200-2 may be defined as peripheral edge portions forming a joinable surface area including both a press-fit end portion 1201 corresponding to an evaporation region and a heat dissipation plate portion 1203 corresponding to a condensation region.

That is, in the case of the heat dissipation device 200 according to an embodiment of the present disclosure, the portions joined by the joining process S40 to be described later corresponds to peripheral edge portions of the heat dissipation plate portion 203, excluding the press-fit end portion 201 formed by the bending process S20. In this respect, it should be noted in advance that these joined portions differ in part from the joined portions of the heat dissipation device 1200 according to another embodiment of the present disclosure, in which two separate metal panel members are joined and sealed.

Meanwhile, as shown in FIGS. 1B and 2B, the heat dissipation device 1200 according to another embodiment of the present disclosure is installed in the press-fit portion 150 that is disposed to extend vertically in an up-and-down direction on a rear surface of the heat-dissipation housing body 110. Thus, a press-fit end portion 1201 corresponding to a front end and an outer end of a heat dissipation plate portion 1203 corresponding to a rear end may be parallel to each other.

In addition, as shown in FIG. 9, the heat dissipation device 1200 according to another embodiment of the present disclosure may further include the auxiliary absorber 301 for improving the absorption rate of the liquid refrigerant by the absorber 300.

The auxiliary absorber 301 described herein may perform a basic function of increasing the absorption rate of the absorber 300 itself, as in the heat dissipation device 200 according to the above-described embodiment of the present disclosure. In addition, as in the heat dissipation device 1200 according to another embodiment of the present disclosure, when it extends further upward beyond the upper end of the heat-dissipation housing body 110 so as to cover the upper end thereof, the auxiliary absorber may serve to allow liquid refrigerant aggregated at the heat dissipation plate portion 1203 corresponding to the upper side of the heat-dissipation housing body 110 to be easily collected and absorbed toward the upper end of the absorber 300.

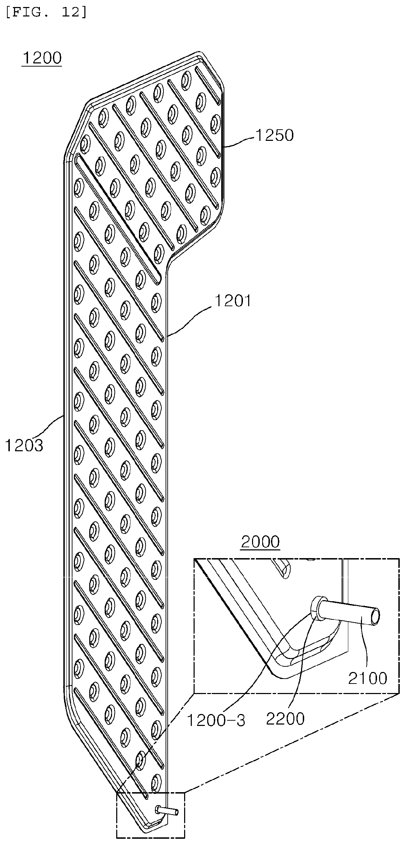

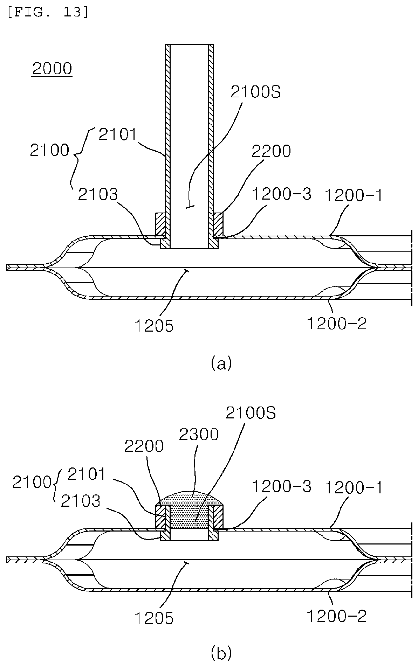

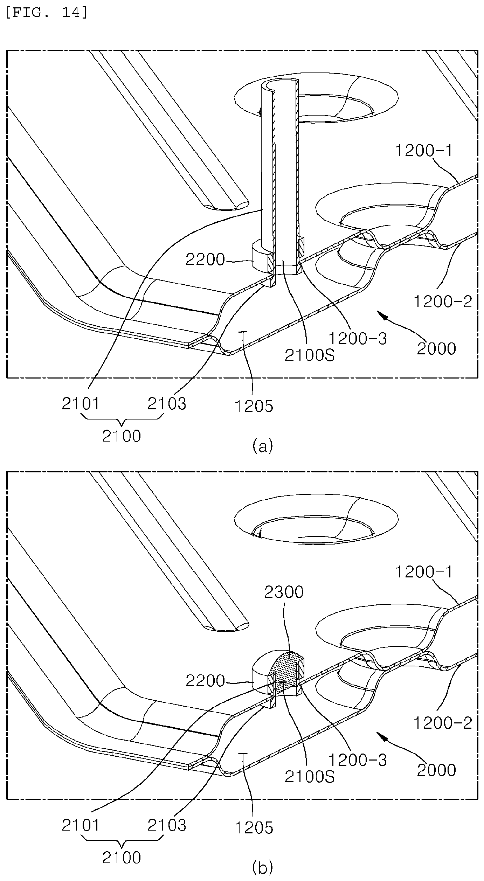

FIG. 12 is a perspective view illustrating a vacuumization portion among components of the heat dissipation device according to embodiments of the present disclosure and a partially enlarged view thereof, FIG. 13 is a cross-sectional view illustrating a vacuumization process using the vacuumization portion among components of the heat dissipation device according to embodiments of the present disclosure, and FIG. 14 is a partially cutaway perspective view of FIG. 13

As shown in FIGS. 12 to 14, the heat dissipation devices 200 and 1200 according to embodiments of the present disclosure may further include a vacuumization portion 2000 provided at an air vent hole 1200-3 formed in one of the first side heat-conduction panels 200-1 and 1200-1 and the second side heat-conduction panels 200-2 and 1200-2 for vacuumizing the refrigerant flow space 205 and 1205 before or after refrigerant is filled in the refrigerant flow space 205 and 1205.

The vacuumization portion 2000 may be understood as an additional component provided for a vacuumization process to be described later, in which air inside the heat-conduction panel bodies 200-1, 200-2, 1200-1, and 1200-2 defining the refrigerant flow space 205 and 1205 is vented by pumping to adjust internal pressure.

Here, the vacuumization portion 2000 may include an air vent tube 2100 that is caught from an inner side to an outer side of the air vent hole 1200-3 and protrudes outward by a predetermined length, and a welding auxiliary ring 2200 mounted on an outer circumferential surface of the air vent tube 2100 for welding fixation of the air vent tube 2100.

The air vent tube 2100 may be provided in a pipe shape having a hollow portion formed therein and may provide a passage through which air is vented via the hollow portion by connecting a pumping mechanism (not shown).

Meanwhile, since the thicknesses of the first side heat-conduction panels 200-1 and 1200-1 and the second side heat-conduction panels 200-2 and 1200-2 are very thin, it is difficult to directly weld the air vent hole 1200-3 itself. Thus, the welding auxiliary ring 2200 serves to provide a soldering location on which a shielding solder portion 2300 to be described later may be seated.

Conversely, when the thicknesses of the first side heat-conduction panels 200-1 and 1200-1 and the second side heat-conduction panels 200-2 and 1200-2 are relatively large, the air vent tube 2100 may be fixed by the thickness itself, and thus the welding auxiliary ring 2200 may be excluded from essential components.

However, in the heat dissipation devices 200 and 1200 according to embodiments of the present disclosure, when the metal panel members forming the heat-conduction panel bodies 200-1, 200-2, 1200-1, and 1200-2 are not formed of conventionally used aluminum (Al) but are instead formed of SUS (stainless steel) having elongation that enables fabrication with a very small thickness as described above, the welding auxiliary ring 2200 may have significance as an essential component.

For reference, although aluminum is a metal material having the advantage of very high thermal conductivity, there is a limitation in that the type of refrigerant that may be filled in the refrigerant flow spaces 205 and 1205 is restricted.

For example, when the heat-conduction panel body is manufactured from a metal panel member made of aluminum, and water (including natural water, distilled water, or ultrapure water) is employed as the refrigerant and filled into the refrigerant flow space 1205, there is a problem in that a predetermined chemical reaction occurs upon contact with water, thereby generating hydrogen gas.

Therefore, in the heat dissipation devices 200 and 1200 according to embodiments of the present disclosure, the heat-conduction panel bodies 200-1, 200-2, 1200-1, and 1200-2 may be manufactured using metal panel members made of SUS, which allows water to be used as the refrigerant. In such a case, the welding auxiliary ring 2200 may be an essential component for smooth installation during the vacuumization process SA through the air vent tube 2100 described above.

In addition, when the material of the heat-conduction panel bodies 200-1, 200-2, 1200-1, and 1200-2 is limited to SUS, as described above, there is an advantage in that, when the press-fit end portion 201 is inserted into the press-fit portion 150 formed on the rear surface of the heat-dissipation housing body 110, at least a portion of the first refrigerant flow path 210 may be machined to extend into an inner side of a front end of the press-fit portion 150.

When the heat-conduction panel bodies 200-1, 200-2, 1200-1, and 1200-2 are manufactured from SUS material in this manner, since SUS has excellent elongation that directly affects processability, the first refrigerant flow paths 210 and 1210, in which the refrigerant (liquid refrigerant) performing a substantial heat conduction role is collected, may be located as close as possible to the heat-generating elements 140. Thus, even when not manufactured from aluminum having relatively high thermal conductivity, there is an advantage in that sufficient heat dissipation performance may be achieved to overcome the relative disadvantage in thermal conductivity.

For reference, although pure aluminum has a much higher elongation than SUS, when aluminum is manufactured in an alloy form to secure material strength, its workability deteriorates. In contrast, in the case of SUS, the heat-conduction panel bodies 200-1, 200-2, 1200-1, and 1200-2 may be processed to a thinner thickness than when they are formed of aluminum alloy material.

Thus, when the heat-conduction panel bodies 200-1, 200-2, 1200-1, and 1200-2 are manufactured to have a thin thickness using SUS material, the welding auxiliary ring 2200 for assisting welding installation of the above-described air vent tube 2100 should be adopted as an essential component.

Here, as shown in FIGS. 13 and 14, the air vent tube 2100 may include a tube body 2101 having a pipe shape with a hollow portion 2100S formed therein, and a stepped locking portion 2103 disposed in the refrigerant flow space 1205 of the tube body 2101 and having an outer circumferential size that is caught by a peripheral edge portion of the air vent hole 1200-3.

Since the air vent tube 2100 has a length that is at least greater than a thickness of the refrigerant flow space 1205, it may be installed, prior to the joining process S40 to be described later, by passing through the air vent hole 1200-3 from an inner side of the heat-conduction panel in which the air vent hole 1200-3 is formed (corresponding to the first side heat-conduction panel 200-1 or 1200-1 in FIGS. 13 and 14) so as to protrude outward by a predetermined length, with the stepped locking portion 2103 being caught by the peripheral edge portion of the air vent hole 1200-3 at a position corresponding to the inner side of the refrigerant flow space 1205.

Thereafter, the above-described welding auxiliary ring 2200 may be fitted and mounted on an outer circumferential surface of the tube body 2101 protruding outward from the air vent hole 1200-3, and an air vent step SA-20 using the tube body 2101 of the air vent tube 2100 may be performed using the pumping mechanism.

In particular, as shown in FIGS. 13 and 14, the welding auxiliary ring 2200 may be fixed in close contact with an outer surface of one of the first side heat-conduction panel 200-1 or 1200-1 and the second side heat-conduction panel 200-2 or 1200-2 in which the air vent hole 1200-3 is formed.

Meanwhile, as shown in FIG. 13(b) and FIG. 14(b), the vacuumization portion 2000 may further include a shielding solder portion 2300 that is soldered to shield the hollow portion 2100S of the tube body 2101 after the tube body 2101 is cut so as to match an outer end of the welding auxiliary ring 2200.

Here, it is preferable that the shielding solder portion 2300 be soldered so as to cover both the outer end of the welding auxiliary ring 2200 and the hollow portion 2100S of the tube body 2101. This is to prevent the air vent tube 2100 from being separated and detached inwardly through the air vent hole 1200-3 after installation.

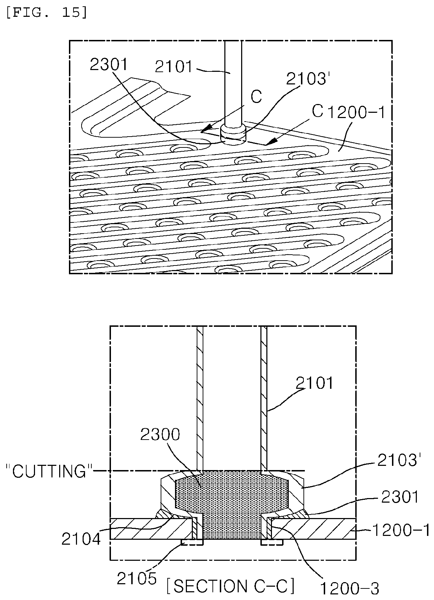

FIG. 15 is a perspective view illustrating another implementation of a vacuumization portion among the components of the heat dissipation device according to embodiments of the present disclosure and a partially enlarged cross-sectional view thereof.

The vacuumization portion 2000 described with reference to FIGS. 12 to 14 is installed such that, before the joining process, it passes through the air vent hole 1200-3 from the inner side of the heat-conduction panel 200-1 or 1200-1 in which the air vent hole 1200-3 is formed, protrudes outward by a predetermined length, and has the stepped locking portion 1203 caught by the peripheral edge portion of the air vent hole 1200-3 at a position corresponding to the inner side of the refrigerant flow space 1205.

This is intended to increase fixing force achieved by a solder caulking step SA-40, to be described later, by additionally mounting the welding auxiliary ring 2200 on the air vent tube 2100. However, it is not necessarily required to include the welding auxiliary ring 2200 as described above.

That is, as shown in FIG. 15, the vacuumization portion 2000 may be configured such that a welding reinforcement portion 2103' corresponding to the above-described welding auxiliary ring 2200 is integrally formed with the tube body 2101, and a coupling direction thereof is different.

More specifically, as shown in FIG. 15, the vacuumization portion 2000 may include an air vent tube 2100 that is caught from an outer side to an inner side of the air vent hole 1200-3 and protrudes outward by a predetermined length. The air vent tube 2100 may include a pipe-shaped tube body 2101 having a hollow portion, and a welding reinforcement portion 2103' formed integrally with the tube body 2101 so as to protrude with a relatively larger outer diameter than that of the tube body 2101.

Here, since the welding reinforcement portion 2103' has an outer diameter relatively larger than that of the tube body 2101, when the tube body 2101 is installed from the outside to the inside through the air vent hole 1200-3, the welding reinforcement portion 2103' may be caught by an outer peripheral edge portion of the air vent hole 1200-3.

At this time, a space in which a fixing solder portion 2301 to be described later may be soldered may be formed between the welding reinforcement portion 2103' and a portion of the outer edge surface of the air vent hole 1200-3. For this purpose, a tapered portion 2104 inclined to form a space into which a filler material may be applied between a portion of the welding reinforcement portion 2103' adjacent to the air vent hole 1200-3 and the outer edge surface of the air vent hole 1200-3 may be provided.

That is, as shown in FIG. 15, the vacuumization portion 2000 may further include a shielding solder portion 2300 that is soldered with the filler material to shield the hollow portion of the tube body 2101 after the tube body 2101 is cut to match the outer end of the welding reinforcement portion 2103', and a fixing solder portion 2301 that is soldered with the filler material to fix the welding reinforcement portion 2103' to the outer peripheral edge portion of the air vent hole 1200-3.

In the vacuumization portion 2000 according to such a modification, since it may be installed from the outside even after the joining process of the first side heat-conduction panel 200-1 and the second side heat-conduction panel 200-2, the installation process may be simplified, and the vacuumization portion may be stably fixed by the shielding solder portion 2300 and the fixing solder portion 2301.

However, the vacuumization portion 2000 according to the modification may also be configured in any suitable manner such that, even after being fixed to the air vent hole 1200-3 formed in one of the first side heat-conduction panel 1200-1 and the second side heat-conduction panel 1200-2 through the solder fixing step SA-30, a locking end 2105 is formed to prevent unintended outward separation (detachment).

In the vacuumization portion 2000 according to the modification, the locking end 2105 not only serves to prevent unintended outward detachment, but also allows the filler material forming the fixing solder portion 2301, when melted, to flow into a space between the welding reinforcement portion 2103' and the air vent hole 1200-3, thereby increasing a joining area and reinforcing rigidity.

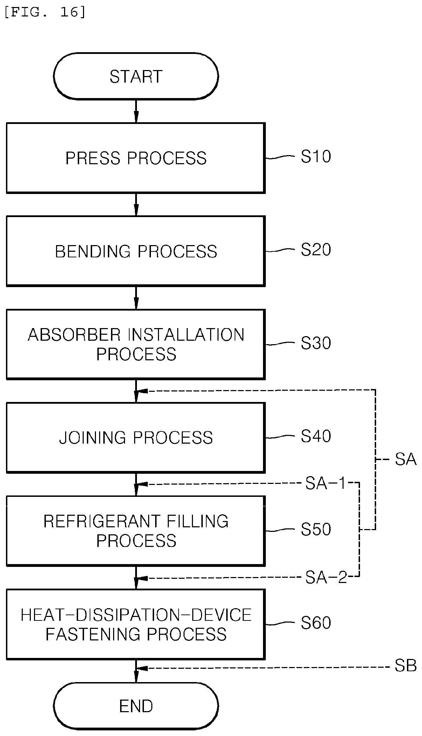

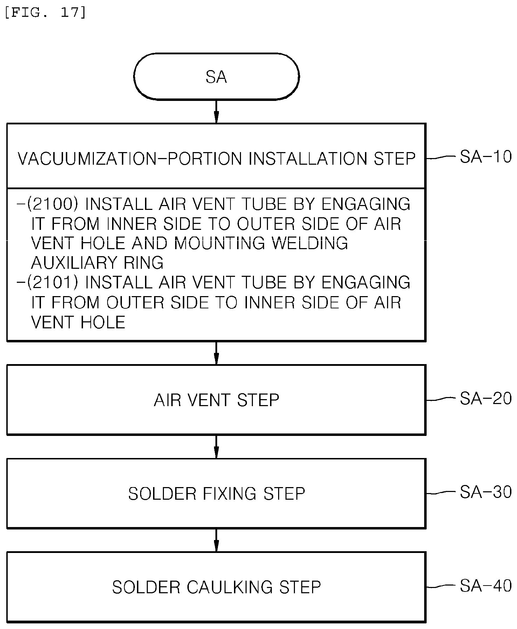

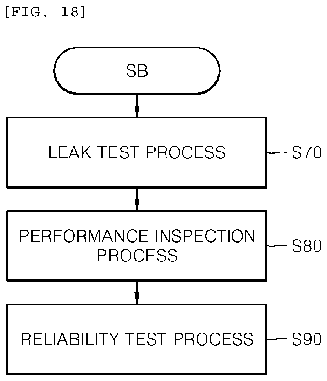

FIG. 16 is a flowchart illustrating a manufacturing method of a heat dissipation device according to embodiments of the present disclosure, FIG. 17 is a flowchart illustrating a detailed process of a vacuumization process SA of FIG. 16, and FIG. 18 is a flowchart illustrating a detailed process of a remaining process SB of FIG. 16.

The method for manufacturing the heat dissipation device according to embodiments of the present disclosure sequentially includes a press process S10, a joining process S40, and a refrigerant filling process S50.

First, a manufacturing method of the heat dissipation device 200 according to an embodiment of the present disclosure, which further includes a bending process S20, will be mainly described as follows.

The manufacturing method of the heat dissipation device 200 according to the embodiment of the present disclosure includes a press process S10 of pressing a heat-conduction panel body 200-1, 200-2 made of a thermally conductive material as a single member so that a first refrigerant flow path 210, a second refrigerant flow path 220, and a third refrigerant flow path 230 are recessed to predetermined depths, respectively.

The press process S10 may be defined as a process of manufacturing a single heat-conduction panel body 200-1, 200-2 having the same specification and standard such that, when bent together, the above-described first to third refrigerant flow paths 210 to 230 and the plurality of strength reinforcing portions 240 are symmetrically formed, as shown in FIG. 4.

Meanwhile, the manufacturing method of the heat dissipation device 200 according to an embodiment of the present disclosure may include, after the press process S10, a bending process S20 of folding a first side heat-conduction panel 200-1 on one side in a width direction and a second side heat-conduction panel 200-2 on the other side in the width direction with respect to a reference line T based on the first refrigerant flow path 210 using a bending jig (not shown), and, after the bending process S20, a joining process S40 of joining peripheral edge portions corresponding to the heat dissipation plate portion 203 of the first side heat-conduction panel 200-1 and the second side heat-conduction panel 200-2 and the plurality of strength reinforcing portions 240 formed in the second refrigerant flow paths 220 and the third refrigerant flow path 230.

In addition, the manufacturing method of the heat dissipation device 200 according to an embodiment of the present disclosure may further include, before the joining process S40, an absorber installation process S30 of installing the absorber 300 that generates capillary force of the liquid refrigerant in a portion corresponding to the first refrigerant flow path 210 near the press-fit end portion 201.

Here, the absorber installation process S30 may be defined as a process performed during execution of the bending process S20, in which the absorber 300 is inserted and installed in the first refrigerant flow path 210 partially formed before completion of the bending process S20.

That is, the absorber 300 may be installed by disposing it in a portion corresponding to the first refrigerant flow path 210 that is partially formed before the first side heat-conduction panel 200-1 and the second side heat-conduction panel 200-2 are completely bent to contact each other with respect to the arbitrary reference line T through the bending process S20. Thereafter, the bending process S20 may be further completed so that the absorber is stably fixed in the portion corresponding to the first refrigerant flow path 210 by the plurality of absorber fixing guides 250.

Thereafter, when the first side heat-conduction panel 200-1 and the second side heat-conduction panel 200-2 are joined along their peripheral edge portions through the above-described joining process S40, both longitudinal ends corresponding to one end and the other end of the press-fit end portion 201 constituting the first refrigerant flow path 210 remain open. Among the two open ends, one end may be caulked for a vacuumization process SA to be performed later. After refrigerant is filled through a refrigerant filling process S50 to be described later, the other open end that has not been caulked may also be caulked and sealed to prevent leakage of the refrigerant inside. As a detailed process of the vacuumization process SA to be described later, a solder caulking step SA-40 may thus be performed.

In addition, the manufacturing method of the heat dissipation device 200 according to an embodiment of the present disclosure may further include, after the joining process S40, a refrigerant filling process S50 of filling refrigerant through one longitudinal end or the other longitudinal end of the first refrigerant flow path 210 (i.e., one of the open ends), and a heat dissipation chamber fastening process S60 of installing the device in the press-fit portion 150 of the heat-dissipation housing body 110 by a press-fit method after the refrigerant filling process S50.

The refrigerant filling process S50 may be performed through one of openings formed at one longitudinal end and the other longitudinal end (i.e., both ends) of the first refrigerant flow path 210, and after the refrigerant is filled, the openings may be completely sealed through the solder caulking step SA-40 to be described later, thereby preventing leakage of the refrigerant.

Meanwhile, although not shown in the drawings, the manufacturing method of the heat dissipation device 1200 according to another embodiment of the present disclosure may differ from the manufacturing method of the heat dissipation device 200 according to the embodiment of the present disclosure described above, which includes the bending process S20, as follows.

That is, the manufacturing method of the heat dissipation device 1200 according to another embodiment of the present disclosure may include a press process S10 of pressing two separate metal panel members, respectively, so as to form refrigerant flow spaces including a first refrigerant flow path 1210 and a second refrigerant flow path 1220 to a predetermined depths, a joining process S40 of, after the press process S10, joining the two separate metal panel members along peripheral edge portions of the heat-conduction panel bodies 1200-1 and 1200-2 to simultaneously form the refrigerant flow space 1205 corresponding to the first refrigerant flow path 1210 and the second refrigerant flow path 1220, and a refrigerant filling process S50 of filling a refrigerant into the refrigerant flow space.

In the manufacturing method of the heat dissipation device 200 according to an embodiment of the present disclosure, the refrigerant flow space 205 including the first refrigerant flow path 210 and the second refrigerant flow path 220 is formed by performing the press process S10 using the single metal panel member, and peripheral edge portions other than the press-fit end portion 201 formed through the bending process S20 are manufactured in a state capable of being joined later by the subsequent joining process S40.

In contrast, in the manufacturing method of the heat dissipation device 1200 according to another embodiment of the present disclosure, two separate metal panel members are each subjected to the press process S10 to form, by sheet-metal forming, portions corresponding to the first refrigerant flow path 1210 and the second refrigerant flow path 1220 together with their peripheral edge portions. Thereafter, the respective peripheral edge portions of the two separate metal panel members may be directly joined using the joining process S40.

Of course, in the manufacturing method of the heat dissipation device 1200 according to another embodiment of the present disclosure, it will be understood that the absorber installation process S30 for installing the absorber 300 or the auxiliary absorber 301 may also be performed prior to the joining process S40.

In addition, when the heat dissipation device 1200 according to another embodiment of the present disclosure includes a plurality of strength reinforcing portions 1240, the joining process S40 may be interpreted as encompassing a process of joining the peripheral edge portions of the two separate metal panel members by a predetermined method while simultaneously joining the plurality of strength reinforcing portions 1240 to each other.

However, the manufacturing method of the heat dissipation device according to an embodiment of the present disclosure may further include, prior to the absorber installation process S30, a cleaning process (not shown) for cleaning the refrigerant flow space 205, and a vacuumization process SA for vacuumizing the refrigerant flow space 205 or 1205 through the vacuumization portion 2000 provided on one of the first side heat-conduction panel 200-1 or 1200-1 and the second side heat-conduction panel 200-2 or 1200-2, either before SA-1 or after SA-2 the refrigerant filling process S50.

Here, the cleaning process may be defined as a process in which the heat dissipation devices 200, 200A, and 200B according to the embodiments of the present disclosure are sequentially immersed in a dipping tank, an ultrasonic tank, a rinsing tank, and a vapor degreasing tank, followed by a drying process to finally remove moisture.

The vacuumization process SA may generally be performed by either a heating-type vacuumization method or a freezing-type vacuumization method. In the heating-type vacuumization method, the interior of the device that operates under vacuum is first vacuumized by pumping, then the refrigerant is filled, after which the refrigerant is heated and vaporized, and the interior is vacuumized once again. Alternatively, in the freezing-type vacuumization method, the refrigerant is first filled, then temporarily frozen (solidified), and thereafter the interior is vacuumized.

For reference, in the former method, that is, the vacuumization process SA in which the refrigerant is filled (injected) after vacuumization, a change in the degree of vacuum occurs during refrigerant filling. Thus, after a high vacuum is first established and the refrigerant is then filled, the internal state changes to a lower vacuum condition. This method, being a more economical process, may be primarily applied to mass production and the manufacture of low-cost products, where price is prioritized over quality.

In addition, in the latter method, that is, the vacuumization process SA involving filling (injecting) the liquid refrigerant followed by freezing of the liquid refrigerant, a first vacuum is performed, the liquid refrigerant is then filled and frozen, and a second vacuum is subsequently performed. Although this method involves a more complex process than the former method, it provides advantages in that it enables a faster reaction speed, minimizes non-condensable gas (NCG), and is favorable for high-vacuum products capable of increasing Qmax. Furthermore, through the freezing process of the liquid refrigerant, the capacity of the vacuum equipment may be reduced and the vacuum exhaust speed may be increased. Thus, this method may be mainly applied to small-scale production and the manufacture of high-end products.

Despite the above-described differences between the detailed vacuumization methods, the vacuumization process SA may include a vacuumization-portion installation step SA-10 of installing the vacuumization portion 2000 in the air vent hole 1200-3, an air vent step SA-20 of vacuumizing the refrigerant flow space 205 or 1205 using the air vent tube 2100 installed in the air vent hole 1200-3, and a solder caulking step SA-40 of cutting a portion of the air vent tube 2100, after the air vent step SA-20, and then soldering the hollow portion 2100S of the air vent tube 2100.

Here, the vacuumization-portion installation step SA-10 may be defined as a step in which, prior to the joining process S40, the air vent tube 2100 is installed such that it is caught by the inner peripheral edge portion of the air vent hole 1200-3 and protrudes outward by a predetermined length, and the welding auxiliary ring 2200 is mounted on the outer circumferential surface of the air vent tube 2100 protruding outward from the air vent hole 1200-3.

Meanwhile, the vacuumization process SA may further include the air vent step SA-20 of vacuumizing the refrigerant flow space 205 using the air vent tube 2100 installed in the air vent hole 1200-3, and the solder caulking step SA-40 of cutting a portion of the air vent tube 2100 after the air vent step SA-20 and then soldering the hollow portion of the air vent tube 2100.

However, the vacuumization process SA described above should be interpreted as a process using the vacuumization portion 2000 shown in FIGS. 11 to 13 (that is, the air vent tube indicated by reference numeral "2100"). In the vacuumization portion 2000 according to the modification shown in FIG. 14 (i.e., the air vent tube indicated by reference numeral "2101"), the process should be understood as being different, as follows.

More specifically, after the joining process S40, the air vent tube 2100 may be installed from the outside toward the inside such that it is caught by the outer peripheral edge portion of the air vent hole 1200-3, and is caught by the outer circumferential surface of the air vent hole 1200-3. This is because the tube body 2101 of the air vent tube 2100 may be installed into the air vent hole 1200-3 from the outer side of the first side heat-conduction panel 200-1 or 1200-1.

Meanwhile, the vacuumization process SA to which the vacuumization portion 2000 according to the modification is applied may be interpreted as further including the air vent step SA-20 of vacuumizing the refrigerant flow space 205 using the air vent tube 2100 installed in the air vent hole 1200-3, the solder fixing step SA-30 of soldering, by a filler metal, between the welding reinforcement portion 2103' integrally formed with the air vent tube 2100 and the outer circumferential surface of the air vent hole 1200-3 after the air vent step SA-20, and the solder caulking step SA-40 of cutting a portion of the air vent tube 2100 after the air vent step SA-20 and then soldering the hollow portion of the air vent tube 2100.

In addition, the method of manufacturing the heat dissipation device 200 or 1200 according to embodiments of the present disclosure may further include, after the solder caulking step SA-40 of the vacuumization process SA, at least one of a leak test process S70 for testing whether the refrigerant leaks, a performance inspection process S80 for finally testing the performance of the heat dissipation device 200 or 1200 of the present disclosure, and a reliability test process S90 for testing the reliability of the heat dissipation device 200 or 1200 of the present disclosure.

Meanwhile, although not shown in the drawings, the method of manufacturing the heat dissipation device according to embodiments of the present disclosure may further include a coating process (not shown) of forming a hydrophobic coating material on one surface of the heat-conduction panel body 200-1, 200-2, 1200-1, or 1200-2 that forms the refrigerant flow space 205 or 1205 through which the refrigerant filled by the refrigerant filling process S50 flows, before the bending process S20 (or the absorber installation process S30).

Here, although the coating layer has been described as being limited to the hydrophobic coating material, it will be readily understood that a hydrophilic coating material may also be used depending on the type of refrigerant or the configuration of the refrigerant flow path.

According to the heat dissipation device 200 or 1200 having the above-described configuration according to embodiments of the present disclosure, heat transfer and heat release are achieved through active phase change of the refrigerant filled therein, thereby overcoming the material limitations of heat dissipation fins configured in a heat sink fin form and realizing significantly improved heat dissipation performance. Therefore, an advantage is provided in that the performance of the antenna device 100 or similar electronic equipment can be greatly enhanced.

In addition, by providing the vacuumization portion 2000 on only one of the first side heat-conduction panel 200-1 or 1200-1 and the second side heat-conduction panel 200-2 or 1200-2 when performing the vacuumization process SA for adjusting the internal pressure of the refrigerant flow space 205 or 1205, it is possible to provide the advantage of manufacturing a high-quality product with no risk of refrigerant leakage.

As described above, a heat dissipation device 200 or 1200 and a manufacturing method thereof according to embodiments of the present disclosure has been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

## Claims

1. A heat dissipation device comprising:
a heat-conduction panel body in which a refrigerant flow space having a predetermined thickness is formed to dissipate heat through a first surface and a second surface,
wherein the heat-conduction panel body comprises a vacuumization portion installed on either the first surface or the second surface to communicate with the refrigerant flow space in a direction perpendicular thereto, the vacuumization portion being configured to vacuumize the refrigerant flow space before a refrigerant is filled into the refrigerant flow space or after the refrigerant is filled therein.

2. The heat dissipation device of claim 1,
wherein the refrigerant flow space of the heat-conduction panel body is a space between a first side heat-conduction panel forming the first surface and a second side heat-conduction panel forming the second surface, the refrigerant flow space being formed as a sealed empty space in which the refrigerant is filled and undergoes phase change to dissipate heat through vapor-liquid circulation, and
wherein the vacuumization portion is provided in an air vent hole formed in either the first side heat-conduction panel or the second side heat-conduction panel.

3. The heat dissipation device of claim 2, wherein the vacuumization portion comprises:
an air vent tube caught from an inner side to an outer side of the air vent hole and protruding outward by a predetermined length; and
a welding auxiliary ring mounted on an outer circumferential surface of the air vent tube to secure the air vent tube by welding.

4. The heat dissipation device of claim 3, wherein the air vent tube comprises:
a pipe-shaped tube body having a hollow portion; and
a stepped locking portion of the tube body located in the refrigerant flow space and having an outer diameter greater than an outer circumference of the tube body.

5. The heat dissipation device of claim 4, wherein the outer diameter of the stepped locking portion is formed to have a size that is caught by an inner peripheral edge portion of the air vent hole.

6. The heat dissipation device of claim 4, wherein the welding auxiliary ring is fixed in close contact with an outer peripheral edge portion of either the first side heat-conduction panel or the second side heat-conduction panel in which the air vent hole is formed.

7. The heat dissipation device of claim 4, wherein the vacuumization portion further comprises a shielding solder portion configured to solder and fix the tube body to the air vent hole.

8. The heat dissipation device of claim 7, wherein the shielding solder portion is a filler material that is soldered to seal the hollow portion of the tube body after the tube body is cut so as to match an outer end of the welding auxiliary ring.

9. The heat dissipation device of claim 7, wherein the shielding solder portion is a filler material that is soldered to cover both the outer end of the welding auxiliary ring and the hollow portion of the tube body cut to match the outer end of the welding auxiliary ring.

10. The heat dissipation device of claim 2,
wherein the vacuumization portion comprises:
an air vent tube caught from the outer side to the inner side of the air vent hole and protruding outward by a predetermined length,
wherein the air vent tube comprises:
a pipe-shaped tube body having a hollow portion; and
a welding reinforcement portion integrally formed on the tube body and caught by an outer peripheral edge portion of the air vent hole.

11. The heat dissipation device of claim 10, wherein a tapered portion is formed at a portion of the welding reinforcement portion adjacent to the air vent hole, the tapered portion being inclined to define a space between the welding reinforcement portion and the outer peripheral edge portion of the air vent hole, into which a filler metal is applicable.

12. The heat dissipation device of claim 10, wherein the welding reinforcement portion has an outer diameter sized to be caught by the outer peripheral edge portion of the air vent hole when the tube body is inserted from the outer side to the inner side through the air vent hole.

13. The heat dissipation device of claim 11, wherein the vacuumization portion further comprises:
a shielding solder portion soldered by the filler material to seal the hollow portion of the tube body after the tube body is cut to match the outer end of the welding reinforcement portion; and
a fixing solder portion soldered by a filler material to secure the welding reinforcement portion to the outer peripheral edge portion of the air vent hole.

14. The heat dissipation device of claim 13, wherein the fixing solder portion is formed by the filler material applied between the air vent hole and the tapered portion of the welding reinforcement portion.

15. A method of manufacturing a heat dissipation device, the method comprising:
a heat-conduction panel body sheet-metal forming process of machining a first side heat-conduction panel and a second side heat-conduction panel that define a refrigerant flow space therein, and integrally forming, in either the first side heat-conduction panel or the second side heat-conduction panel, an air vent hole for refrigerant filling or vacuumization;
after the heat-conduction panel body sheet-metal forming process, a joining process of joining the first side heat-conduction panel and the second side heat-conduction panel to each other to form the refrigerant flow space, wherein the first and second side heat-conduction panels are formed of either a single metal panel member or two metal panel members; and
after the joining process, a vacuumization process of vacuumizing the refrigerant flow space,
wherein the vacuumization process comprises a vacuumization-portion installation operation of installing a vacuumization portion in the air vent hole.

16. The method of claim 15, further comprising:
when the first side heat-conduction panel and the second side heat-conduction panel are formed of the single metal panel member, a bending process of bending the single metal panel member before the joining process such that the first side heat-conduction panel forms one side surface of the refrigerant flow space and the second side heat-conduction panel forms the other side surface of the refrigerant flow space.

17. The method of claim 15, wherein the vacuumization-portion installation operation comprises installing an air vent tube, prior to the joining process, such that the air vent tube is caught by an inner peripheral edge portion of the air vent hole and protrudes outward by a predetermined length, and mounting a welding auxiliary ring on an outer circumferential surface of the air vent tube protruding outward from the air vent hole.

18. The method of claim 17, wherein the vacuumization process further comprises:
an air vent operation of vacuumizing the refrigerant flow space using the air vent tube installed in the air vent hole; and
a solder caulking operation of cutting a portion of the air vent tube after the air vent operation and then soldering a hollow portion of the air vent tube.

19. The method of claim 15, wherein the vacuumization-portion installation operation comprises:
after the joining process, installing an air vent tube from an outer side toward an inner side so that the air vent tube is caught by an outer peripheral edge portion of the air vent hole, the air vent tube being mounted so as to be caught by the outer peripheral edge portion of the air vent hole.

20. The method of claim 19, wherein the vacuumization process further comprises:
an air vent operation of vacuumizing the refrigerant flow space using the air vent tube installed in the air vent hole;
a solder fixing operation of soldering, by a filler metal, between a welding reinforcement portion integrally formed on the air vent tube and an outer circumferential surface of the air vent hole, after the air vent operation; and
a solder caulking operation of cutting a portion of the air vent tube and then soldering a hollow portion of the air vent tube, after the air vent operation.
